# EUROPEAN PATENT APPLICATION

(11) **EP 1 583 134 A2**
(43) Date of publication of application: **05.10.2005**
(21) Application number: 05006439.3
(22) Date of filing: 23.03.2005
(51) Int. Cl.: H01L 21/00

(54) **Lid unit for thin plate supporting container**

(30) Priority: 31.03.2004 JP 2004104675
(71) Applicant: Miraial Co., Ltd., Tokyo (JP)
(72) Inventor: Kawashima, Yoshio c/o Kumamoto Plant,, Shisui-machi, Kikuchi-gun, Kumamoto-ken (JP)
(74) Representative: Grünecker, Kinkeldey, Stockmair & Schwanhäusser Anwaltssozietät

(57) **Abstract**

A lid unit seals a container main body of a thin-plate supporting container which is conveyed while plural 300 mm-diameter semiconductor wafers are stored in the container. In a wafer retainer which supports the wafers stored in the container main body, the maximum amount of displacement is set in a range of 1.5 to 2.5 mm (ranges from 1/200 to 1/120 of the semiconductor wafer diameter), and proportionality is held between the amount of displacement and external force when the maximum amount of displacement ranges from 1.5 to 2.5 mm. In the states in which the wafer retainer is fitted in the container main body and force is not applied, the wafer retainer is arranged at a position in which the wafer retainer is not in contact with the semiconductor wafers stored in the container main body or at a position in which the wafer retainer is in slight contact with the semiconductor wafers. Therefore, the lid unit can be attached and detached without fixing the container main body, so that vibration-resistant performance and shock-resistant performance are improved by preventing spring resistance force from rapidly increasing, and automatization of the attachment and detachment of the lid unit is easy to realize.

## Description

### BACKGROUND OF THE INVENTION

### Field of the Invention

The present invention relates to a lid unit for a thin plate supporting container used for storage, transport, a manufacturing line, and the like of thin plates such as semiconductor wafers, storage disks, and liquid crystal glass substrates while the thin plates are stored therein, particularly to the lid unit for a thin plate supporting container which is suitable for the storage and transport of disk-shaped thin plates having diameters of 300 mm.

### Description of the Related Art

The thin-plate supporting container used for the storage and transport of the thin plates such as the semiconductor wafers is well known.

The thin-plate supporting container mainly includes a container main body and a lid unit which covers an upper opening of the container main body. A member which supports the thin plate such as the semiconductor wafer is provided inside the container main body. In order to prevent contamination of a surface of the thin plate such as the semiconductor wafer stored in the thin-plate supporting container, it is necessary to transport the thin-plate supporting container while the inside of the thin-plate supporting container is kept clean, so that the thin-plate supporting container is sealed. That is, the lid unit is fixed to the container main body to seal the container main body.

A thin-plate retainer is provided on the lid unit side. The thin-plate retainer supports the plural thin plates stored in the container main body from the upper side. The thin-plate retainer is attached to the inside surface of the lid unit, and the lid unit is attached to the container main body, which allows the thin-plate retainer to be fitted into each of the thin plates stored in the container main body to support the thin plates. Further, in consideration of vibration and the like, the thin-plate retainer is designed to be slightly displaced while fitted into each of the thin plates. The thin-plate retainer is designed so that usually the amount of displacement has linearity up to about 0.3 mm. That is, a range where proportionality is held between the amount of displacement and external force is set up to about 0.3 mm.

However, in the thin-plate retainer, since the range where the linearity is held exists within about 0.3 mm, an existence position tolerance of the thin plate ranges from about -0.15 mm to about +0.15 mm. Recently the amount of displacement of the thin-plate retainer is also increased as the size of the thin plate such as the semiconductor wafer is enlarged. In the lid unit for a thin plate supporting container for the 300 mm-diameter thin plate, conventionally the existence position tolerance of the thin plate ranges from about -1.0 mm to about +1.0 mm. Further, due to the recent improvement of molding accuracy, the existence position tolerance of the thin plate is improved to the range of about -0.5 mm to about + 0.5 mm. However, even in this case, sometimes the thin-plate retainer is displaced beyond the linearity range, when the range in which the proportionality is held between the amount of displacement and the external force is set up to about 0.3 mm. When the thin-plate retainer is displaced beyond the linearity range, spring resistance force is rapidly increased, which generates the problem that the lid unit is not closed or the lid unit is deformed.

When the lid unit is fixed to the container main body, as described above, it is necessary that the lid unit is strongly pressed against the container main body. Therefore, it is necessary that the container main body is fixed, and automatization of attachment and detachment of the lid unit is not easy to realize.

### SUMMARY OF THE INVENTION

An object of the invention is to provide a lid unit for a thin plate supporting container which solves the problem associated with the increase in thin-plate size.

A lid unit for a thin plate supporting container according to the invention, with which a container main body of a thin-plate supporting container is covered, the thin-plate supporting container in which a plurality of disk-shaped thin plates are stored and conveyed, the lid unit includes a thin-plate retainer which supports the disk-shaped thin plates stored in the container main body, where the maximum amount of displacement of the thin-plate retainer is set in a range of 1/200 to 1/120 of a diameter of the disk-shaped thin plate. For example, for the disk-shaped thin plate having the diameter of 300 mm, the maximum amount of displacement of the thin-plate retainer which supports the disk-shaped thin plate is set in the range of 1.5 to 2.5 mm.

According to the above configuration, even if the size of the thin plate is enlarged to 300 mm to increase the amount of shift, the amount of shift caused by the enlargement of the size is absorbed by the amount of displacement of the thin-plate retainer to support the thin plate.

The thin-plate retainer is set so that the proportionality is held between the amount of displacement of the thin-plate retainer and external force when the maximum amount of displacement of the thin-plate retainer ranges from 1.5 mm to 2.5 mm. The spring resistance force of the thin-plate retainer is never rapidly increased by supporting the thin plate within the range where the proportionality is held between the amount of displacement of the thin-plate retainer and external force.

It is desirable that the thin-plate retainer is arranged at a position in which the thin-plate retainer is not in contact with the disk-shaped thin plates stored in the container main body or at a position in which the thin-plate retainer is in slight contact with the disk-shaped thin plates in the states in which the lid unit for the thin-plate retainer is fitted in the container main body and any force is not applied. Therefore, in the state in which the lid unit for a thin plate supporting container is fitted in the container main body, the lid unit for a thin plate supporting container can be fixed to the container main body without pressing the lid unit for a thin plate supporting container against the container main body.

As described above, according to the lid unit for a thin plate supporting container of the invention, the following effects can be obtained.
(1) The maximum amount of displacement of the wafer retainer is set in the range of 1.5 to 2.5 mm. Therefore, even in the thin plate having the diameter of 300 mm, the thin plate is supported by absorbing the increase in displacement amount associated with the enlargement of the thin plate size, and the spring resistance force of the thin-plate retainer can be prevented from rapidly increasing.
(2) The proportionality is held between the amount of displacement and the external force when the maximum amount of displacement of the wafer retainer is set in the range of 1.5 to 2.5 mm. Therefore, the spring resistance force of the wafer retainer is not rapidly increased, and the thin-plate supporting container which is excellent for the vibration-resistant performance and shock-resistant performance can be provided.
(3) Even if the lid unit for a thin plate supporting container is slightly fitted in the container main body, the thin-plate retainer is not in contact with the disk-shaped thin plates. Therefore, the disk-shaped thin plates can be fixed without strongly pressing the lid unit for a thin plate supporting container, and the automatization of the attachment and detachment of the lid unit can be easily realized.

### BRIEF DESCRIPTION OF THE DRAWINGS

Fig. 1 is a perspective view showing a wafer retainer according to a first embodiment of the invention;
Fig. 2 is a perspective view showing a thin-plate supporting container according to the first embodiment of the invention;
Fig. 3 is a perspective view showing the thin-plate supporting container according to the first embodiment of the invention while a lid unit is uncovered;
Fig. 4 is a partially perspective view showing a lid unit supporting portion of the thin-plate supporting container according to the first embodiment of the invention;
Fig. 5 is a partially sectional view showing the lid unit supporting portion of the thin-plate supporting container according to the first embodiment of the invention;
Fig. 6 is a perspective view showing a top surface of a manufacturing line lid unit according to the first embodiment of the invention;
Fig. 7 is a perspective view showing a bottom surface of the manufacturing line lid unit according to the first embodiment of the invention;
Fig. 8 is a partially perspective view showing the manufacturing line lid unit according to the first embodiment of the invention;
Fig. 9 is a perspective view showing the top surface of a latch member according to the first embodiment of the invention;
Fig. 10 is a perspective view showing the bottom surface of the latch member according to the first embodiment of the invention;
Fig. 11 is a sectional side view showing the latch member according to the first embodiment of the invention;
Fig. 12 is a perspective view showing the top surface of a feed member according to the first embodiment of the invention;
Fig. 13 is a perspective view showing the bottom surface of the feed member according to the first embodiment of the invention;
Fig. 14 is a plan view showing the feed member according to the first embodiment of the invention;
Fig. 15 is a bottom view showing the feed member according to the first embodiment of the invention;
Fig. 16 is a perspective view showing the top surface of a hold cover according to the first embodiment of the invention;
Fig. 17 is a perspective view showing the bottom surface of the hold cover according to the first embodiment of the invention;
Fig. 18 is a perspective view showing the top surface of a cover clamp according to the first embodiment of the invention;
Fig. 19 is a perspective view showing the bottom surface of the cover clamp according to the first embodiment of the invention;
Fig. 20 is a side view showing the top surface of a wafer retainer according to the first embodiment of the invention;
Fig. 21 is a perspective view showing the wafer retainer according to the first embodiment of the invention;
Fig. 22 is a perspective view showing a lid unit holder according to the first embodiment of the invention;
Fig. 23 is a graph showing a spring characteristics of an elastic support plate according to the first embodiment of the invention;
Fig. 24 is a graph showing the spring characteristics comparison between the conventional example and the elastic support plate according to the first embodiment of the invention;
Fig. 25 is a schematic view showing an operation of simplified detaching mechanism according to the first embodiment of the invention;
Fig. 26 is a side view showing the wafer retainer according to a first modification example in the first embodiment of the invention;
Fig. 27 is a perspective view showing the wafer retainer according to the first modification example in the first embodiment of the invention;
Fig. 28 is a perspective view showing the wafer retainer according to the first modification example in the first embodiment of the invention;
Fig. 29 is a perspective view showing the wafer retainer according to a second modification example in the first embodiment of the invention;
Fig. 30 is a front elevation showing the wafer retainer according to the second modification example in the first embodiment of the invention;
Fig. 31 is a perspective view showing the wafer retainer according to a third modification example in the first embodiment of the invention;
Fig. 32 is a sectional view showing a main portion of the wafer retainer according to the third modification example in the first embodiment of the invention;
Fig. 33 is a perspective view showing the wafer retainer according to a fourth modification example in the first embodiment of the invention;
Fig. 34 is a front elevation showing the wafer retainer according to the fourth modification example in the first embodiment of the invention;
Fig. 35 is a sectional view showing the main portion of the wafer retainer according to a second embodiment of the invention;
Fig. 36 is a perspective view showing a backside of the lid unit including the wafer retainer according to the second embodiment of the invention;
Fig. 37 is a partially perspective view showing a backside of the lid unit according to the second embodiment of the invention while the wafer retainer is included;
Fig. 38 is a perspective view showing the main portion of a backside of the lid unit according to the second embodiment of the invention while the wafer retainer is excluded;
Fig. 39 is a perspective view showing the main portion of the backside of the lid unit according to the second embodiment of the invention while the wafer retainer is excluded;
Fig. 40 is a sectional perspective view showing a support rib according to the second embodiment of the invention;
Fig. 41 is an enlarged view showing the main portion of the wafer retainer according to the second embodiment of the invention;
Fig. 42 is an enlarged view showing the main portion of an engagement piece of the wafer retainer according to the second embodiment of the invention;
Fig. 43 is an enlarged view showing the main portion of the engagement piece of the wafer retainer according to the second embodiment of the invention;
Fig. 44 is an enlarged view showing the main portion of the engagement piece of the wafer retainer according to the second embodiment of the invention; and
Fig. 45 is an enlarged view showing the main portion of a modification example in the second embodiment of the invention.

### DETAILED DESCRIPTION OF THE PREFERRED EMBODIMENTS

Referring now to the accompanying drawings, preferred embodiments of the invention will be described below. The thin-plate supporting container of the invention is a container which is used for the storage, the transport, the manufacturing line, and the like while the thin plates such as the semiconductor wafer, the storage disk, and the liquid crystal glass substrate are stored in the thin plate support container. The thin-plate supporting container in which the semiconductor wafers having a diameter of 300 mm are stored will be described as an example in the following embodiments. The transport lid unit and the lid unit used in the manufacturing line are separately used as the lid unit which closes the thin-plate supporting container.

### First Embodiment

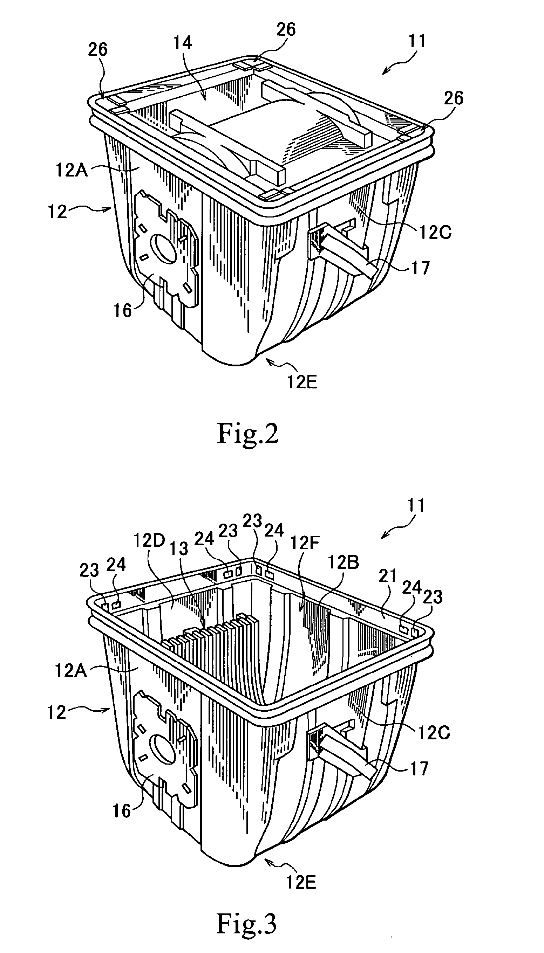

As shown in Figs. 2 to 7, a thin-plate supporting container 11 according to a first embodiment includes a container main body 12 in which the plural semiconductor wafers (not shown) are stored, two thin plate supports 13, a transport lid unit 14 and a manufacturing line lid unit 15 which close the container main body 12, a top flange 16 which is grasped by an arm of a conveying apparatus (not shown) in a plant, and a carrying handle 17 which an operator grasps when the operator manually carries the thin-plate supporting container 11. The two thin plate supports 13 are respectively provided in sidewalls opposite each other in the container main body 12, and the two thin plate supports 13 support the semiconductor wafer stored in the container main body 12 from both sides.

As shown in Figs. 2 and 3, the whole of container main body 12 is formed in a substantial cube. When the container main body 12 is placed in a vertical position (Figs. 2 and 3), the container main body 12 includes four sidewalls 12A, 12B, 12C, and 12D which become a surrounding wall and a bottom 12E, and an opening 12F is provided on the top portion of the surrounding wall. The container main body 12 is horizontally placed when installed opposite a wafer carrying robot (not shown) in the manufacturing line of the semiconductor wafer and the like. Positioning means (not shown) for positioning the thin-plate supporting container 11 is provided outside the sidewall 12B which becomes the bottom when the container main body 12 is horizontally placed. The top flange 16 is detachably attached outside the sidewall 12A which becomes a ceiling when the container main body 12 is horizontally placed. The carrying handle 17 is detachably attached to the outside of the sidewalls 12C and 12D which become a side wall when the container main body 12 is horizontally placed.

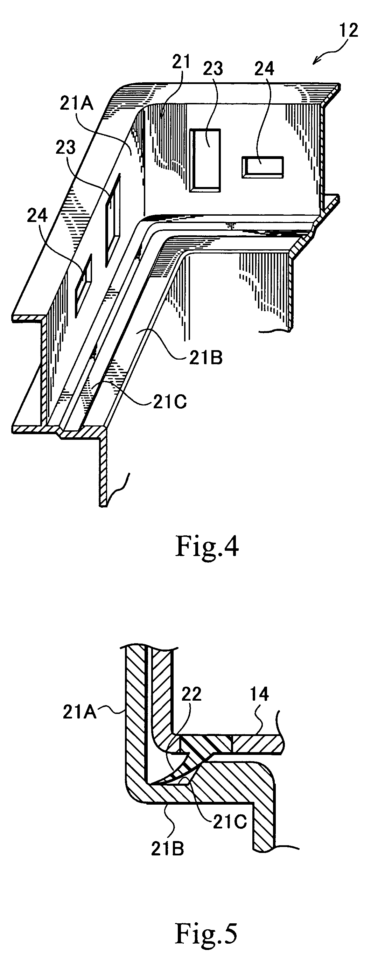

As shown in Figs. 4 and 5, a lid unit holder 21 into which the lid unit 4 is fitted is provided in upper end portions of the sidewalls 12A, 12B, 12C, and 12D of the container main body 12. The lid unit holder 21 is formed so that the upper end portion of the container main body 12 is enlarged to dimensions of the lid unit 4. Therefore, the lid unit 4 is fitted inside the vertical plate 21A of the lid unit holder 21 to engage a horizontal plate 21B, which allows the lid unit to be attached to the lid unit holder 21. A sealing groove 21C is provided in a perimeter of the horizontal plate 21B, and a gasket 22 attached to a lower surface of the transport lid unit 14 is fitted in the seal groove 21C to seal the thin-plate supporting container 11. In each inside surface of the vertical plates 21A located at four corners of the lid unit holder 21, a first fitted portion 23 is provided so that a lid unit latch pawl (not shown) of the later-mentioned transport simplified detaching mechanism 26 is fitted to fix the transport lid unit 14 onto the container main body 12 side. The first fitted portion 23 is formed by recessing the vertical plate 21A in a rectangle shape, and the lid unit latch pawl is fitted in the rectangle recess.

A second fitted portion 24 is provided near each first fitted portion 23. The second fitted portion 24 is used in the manufacturing line. A latch member 42 of a simplified detaching mechanism 32 of the manufacturing line lid unit 15 is fitted in the second fitted portion 24 to fix the manufacturing line lid unit 15 onto the container main body 12 side.

The transport lid unit 14 is the well-known lid unit. The transport lid unit 14 is formed in a dish shape, and a central portion of the transport lid unit 14 is formed in a cylindrical shape arising from the surface so as not to come into contact with the upper portion of the stored semiconductor wafer.

As shown in Figs. 2 and 3, the transport simplified detaching mechanism 26 which detachably fixes the transport lid unit 14 to the container main body 12 is provided at each of the four corners of the transport lid unit 14. The transport simplified detaching mechanism 26 includes the lid unit latch pawl (not shown) which is provided while projected from a peripheral portion of the transport lid unit 14. The lid unit latch pawl is arranged to be fitted in the first fitted portion 23.

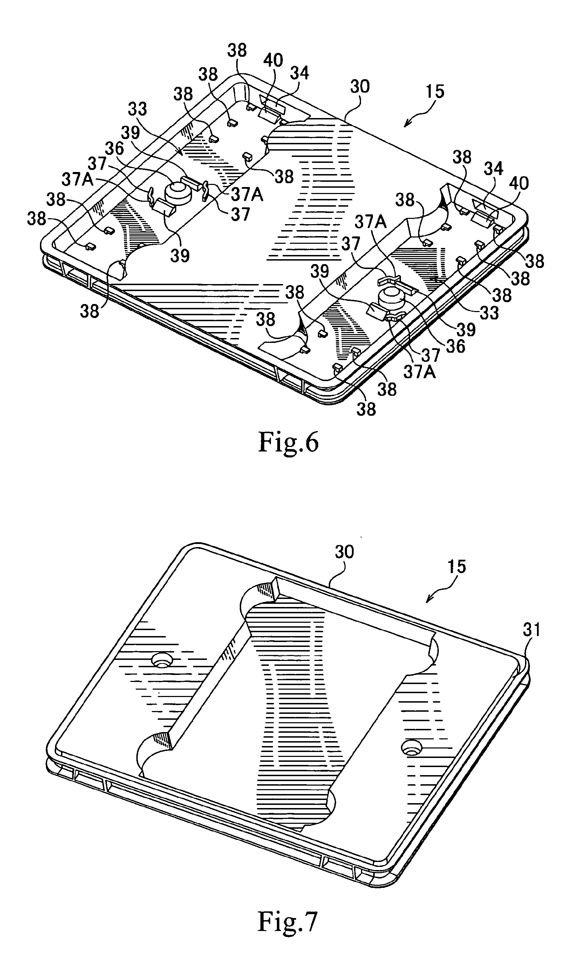

The manufacturing line lid unit 15 is a lid unit which causes the container main body 12 of the transported thin-plate supporting container 11 to be used in the manufacturing line in the plant. In the semiconductor manufacturing plant and the like, the manufacturing line lid unit 15 is arranged as a single product independent of the thin-plate supporting container 11. As shown in Figs. 6 and 7, the manufacturing line lid unit 15 includes a main body 30, a cover plate (not shown), and the simplified detaching mechanism 32.

The main body 30 is formed thinly in a substantial square shape as a whole. The main body 30 is designed not to extend off when attached to the lid unit holder 21 of the container main body 12. A gasket holder 31 is attached to a periphery of the lower portion of the main body 30, and a gasket (not shown) is provided in the gasket holder 31. When the main body 30 is attached to lid unit holder 21, the gasket holder 31 is fitted in the sealing groove 21C to seal the container main body 12. As with the gasket 22 of the transport lid unit 14, the gasket is appropriately formed in accordance with the shape of the sealing groove 21C.

In the manufacturing line lid unit 15, recesses 33 to which the simplified detaching mechanisms 32 are attached are provided in end portions on both sides in a longitudinal direction of the main body 30 (upper left and lower right in Fig. 6) respectively. The recess 33 is formed in a substantial rectangle by recessing the end portion of the main body 30. Openings 34 which a leading-end fitting portion 56 of the later-mentioned latch member 42 appears from and disappears in are provided in both ends in the longitudinal direction of the recess 33 (upper right and lower left in Fig. 6) respectively. The opening 34 is provided at a position where the opening 34 matches the second fitted portion 24 of the lid unit holder 21 when the main body 30 is fitted in the lid unit holder 21. A rotating support shaft 36, a stopper 37, a latch pawl 38, a base-end lower cam 39, and a leading-end cam 40 are provided in the bottom portion of the recess 33. A cover plate is detachably attached to the recess 33. The cover plate is detached when the simplified detaching mechanism 32 provided in the recess 33 is cleaned.

The rotating support shaft 36 is a member which rotatably supports the later-mentioned feed member 43. The rotating support shaft 36 is formed in the cylindrical shape projecting from the bottom portion. The rotating support shaft 36 is fitted in a rotating cylinder portion 63 of the feed member 43 to rotatably support the feed member 43. The stopper 37 supports the feed member 43 while rotating the feed member 43 to a predetermined angle. The stopper 37 includes two plate-shaped members projecting from the bottom portion around the rotating support shaft 36. A holder 37A is formed by bending the plate-shaped member. The feed member 43 is held at the predetermined angle by fitting a projection 65A of a latch piece 65 of the feed member 43 into the holder 37A.

The latch pawl 38 is a member which fixes the later-mentioned cover clamp 46 to the bottom portion of the recess 33. Because the cover clamps 46 are attached to the both sides in the longitudinal direction of the recess 33, each six latch pawls 38 are also attached to the both side in the longitudinal direction of the recess 33 respectively. The latch pawl 38 includes an L-shaped member, and a lower support plate piece 88 of the cover clamp 46 is fitted in the latch pawl 38.

The base-end lower cam 39 and the leading-end cam 40 constitute the later-mentioned cam mechanism 44. The base-end lower cam 39 and the later-mentioned base-end upper cam 53 constitute a base-end side cam which pushes down a base end side of the latch member 42 when the latch member 42 is fed.

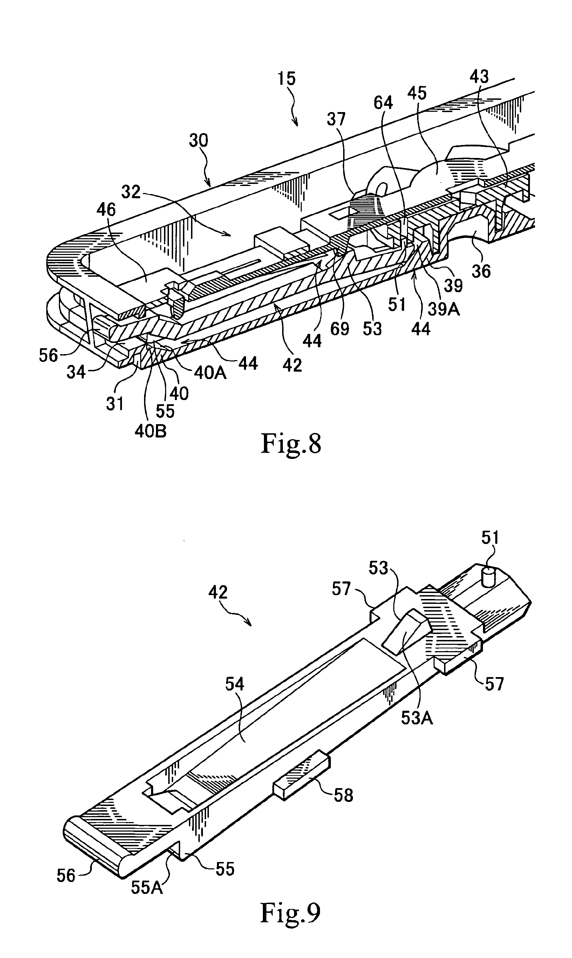

As shown in Figs. 7 and 8, the base-end lower cam 39 pushes down the base end side of the latch member 42 to the other end (lower side in Fig. 8) as the latch member 42 is fed. The base-end lower cams 39 are provided on the both side of the rotating support shaft 36 respectively. In the sectional side view, the base-end lower cam 39 is formed in a substantial triangle, and the base-end lower cam 39 includes a slope 39A which vertically moved the base-end side of the latch member 42. Mirror polishing is performed to the slope 39A in order to decrease frictional resistance between the slope 39A and a base-end slide surface 52 of the latch member 42.

The leading-end cam 40 pushes (lifts up) the leading-end fitting portion 56 of the latch member 42 to the other end (upper side in Fig. 8) as the latch member 42 is fed. The leading-end cams 40 are provided while facing the openings 34 at the both ends in the longitudinal direction of the recess 33 respectively. In the sectional side view, the leading-end cams 40 is formed in the substantial triangle, and the leading-end cams 40 includes a slope 40A which upwardly moved the leading-end side of the latch member 42. The mirror polishing is performed to the slope 40A in order to decrease the frictional resistance between the slope 40A and a lead-end slide surface 55A of a fulcrum portion 55 of the latch member 42. A fitting recess 40B is provided in the upper end portion of the slope 40A. The fulcrum portion 55 of the latch member 42 is fitted in the fitting recess 40B.

The simplified detaching mechanism 32 is provided in the recess 33. The simplified detaching mechanism 32 causes the manufacturing line lid unit 15 to be easily attached to and detached from the container main body 12. As shown in Fig. 8, the simplified detaching mechanism 32 includes the latch member 42, the feed member 43, the cam mechanism 44, a hold cover 45, and the cover clamp 46.

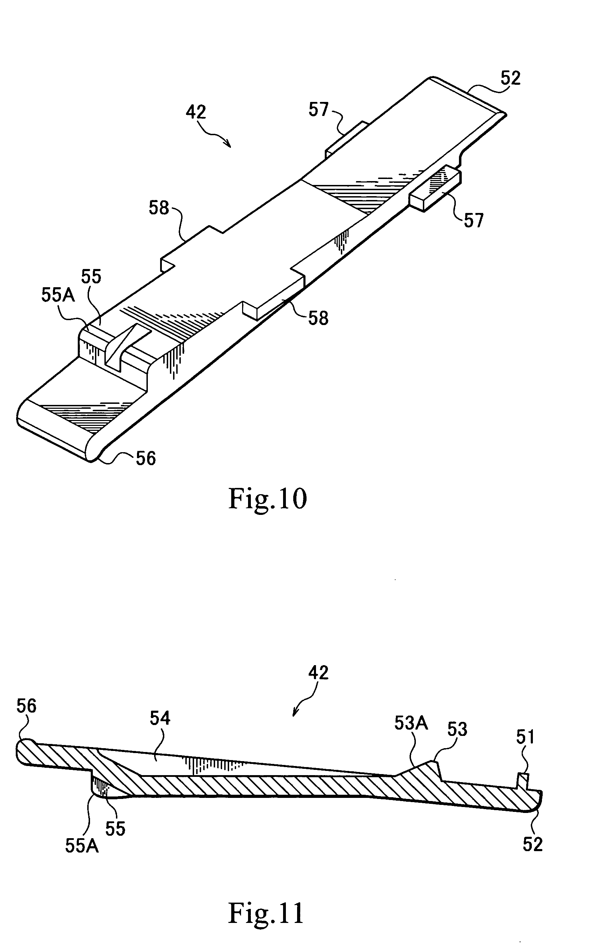

The latch member 42 is fitted in the second fitted portion 24 of the lid unit holder 21 by extending from the opening 34 of the main body 30 while the manufacturing line lid unit 15 is attached to the lid unit holder 21 of the container main body 12. As shown in Figs. 8 to 11, the latch member 42 includes a connecting shaft 51, the base-end slide surface 52, the base-end upper cam 53, an upper groove 54, the fulcrum portion 55, the leading-end fitting portion 56, a base-end side-plate 57, and a leading-end side-plate 58.

The connecting shaft 51 is fitted in a long hole 64 of the feed member 43 to connect the feed member 43 and the latch member 42. The connecting shaft 51 is formed in a round bar, and the connecting shaft 51 is provided in the base end portion of the latch member 42 while facing upward.

The base-end slide surface 52 slides to the slope 39A of the base-end lower cam 39 to vertically move the base end portion of the latch member 42. The base-end slide surface 52 is formed by obliquely cutting away the lower side of the base end portion of the latch member 42. The mirror polishing is performed to the base-end slide surface 52 in order to decrease the frictional resistance between the base-end slide surface 52 and a slope 39A of the base-end lower cam 39. When the base-end slide surface 52 slides to the slope 39A of the base-end lower cam 39, the base end portion of the latch member 42 is pushed down by feeding the latch member 42. Therefore, the base-end lower portion of the latch member 42 is pushed up by pulling in the latch member 42.

The base-end upper cam 53 vertically moves the base end portion of the latch member 42 in conjunction with base-end lower cam 39. The base-end upper cam 53 is a part which acts as a power point in leverage principle. However, the connecting shaft 51 does not act as the power point in the leverage principle, and the connecting shaft 51 is a part which simply receives the force in the longitudinal direction when the latch member 42 is caused to appear and disappear.

The base-end upper cam 53 is provided near the base end portion of the latch member 42 while facing upward. In the sectional side view, the base-end upper cam 53 is formed in the substantial triangle shape, and the base-end upper cam 53 includes a slope 53Awhich vertically moved the base-end side of the latch member 42. As with the slope 39A of the base-end lower cam 39, the mirror polishing is performed to the slope 53A of the base-end upper cam 53, and the base-end upper cam 53 is arranged to slide to a cam holder projection 69 on the holder cover 45 side as mentioned later. The slope 53A of the base-end upper cam 53 is set so as to be substantially parallel to the slope 39A of the base-end lower cam 39. Therefore, when the latch member 42 is fed while the cam holder projection 69 slides to the slope 53A of the base-end upper cam 53, the base-end upper cam 53 is pushed by the cam holder projection 69 to push down the base end portion of the latch member 42. When the latch member 42 is pulled in, the base-end slide surface 52 is pushed by the slope 39A of the base-end lower cam 39 to push up the base end portion of the latch member 42.

The fulcrum portion 55 holds the leading end portion of the latch member 42 to act as a rotating center. The fulcrum portion 55 acts as the fulcrum in the leverage principle. The fulcrum portion 55 is provided on the lower side near the leading end of the latch member 42 while formed in the substantially square-cornered shape. The leading-end slide surface 55A is formed in a top portion of the fulcrum portion 55A. The leading-end slide surface 55A slides to the slope 40A of the leading-end cam 40 to verticallymove the leading-end fitting portion 56 of the latch member 42. The leading-end slide surface 55A is formed by obliquely cutting away the top portion of the fulcrum portion 55. The mirror polishing is performed to the leading-end slide surface 55A in order to decrease the frictional resistance between the leading-end slide surface 55A and the slope 40A of the leading-end cam 40. Therefore, when the latch member 42 is fed while the leading-end slide surface 55A slides to the slope 40A of the leading-end cam 40, the leading-end fitting portion 56 of the latch member 42 is pushed up to pull in the latch member 42, which allows the leading end portion of the latch member 42 to be pushed down.

The fulcrum portion 55 is fitted in the fitting recess 40B of the leading-end cam 40 to be rotated about the fitting recess 40B.

The leading-end fitting portion 56 is directly fitted in the second fitted portion 24 of the lid unit holder 21 by extending from the opening 34 of the recess 33 to the outside. The leading-end fitting portion 56 acts as a point of application in the leverage principle. The leading-end fitting portion 56 is provided to be slightly separated from the fulcrum portion 55 so that the leading-end fitting portion 56 can sufficiently exert force while fitted in the second fitted portion 24 of the lid unit holder 21.

The base-end side-plate 57 and the leading-end side-plate 58 are the members which hold the latch member 42 to permit the reciprocal movement of the latch member 42.

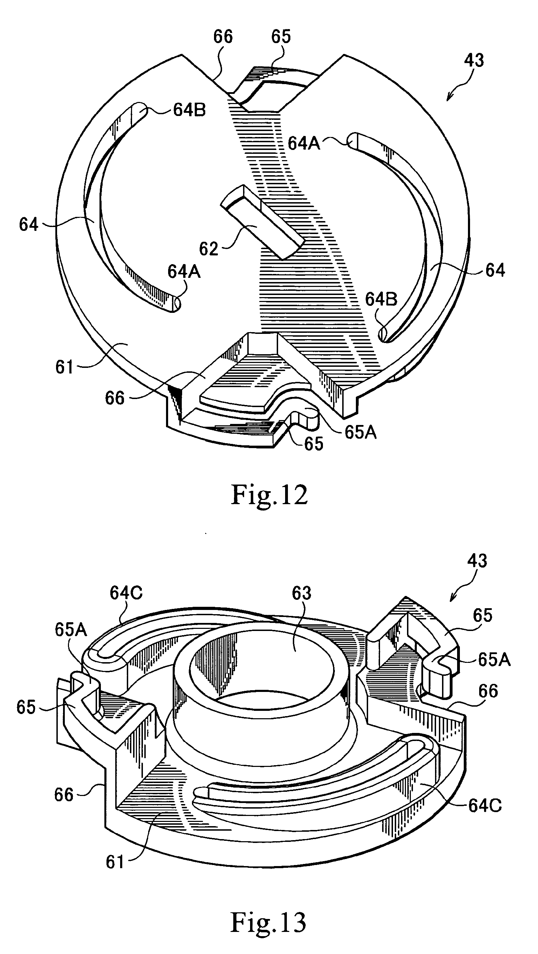

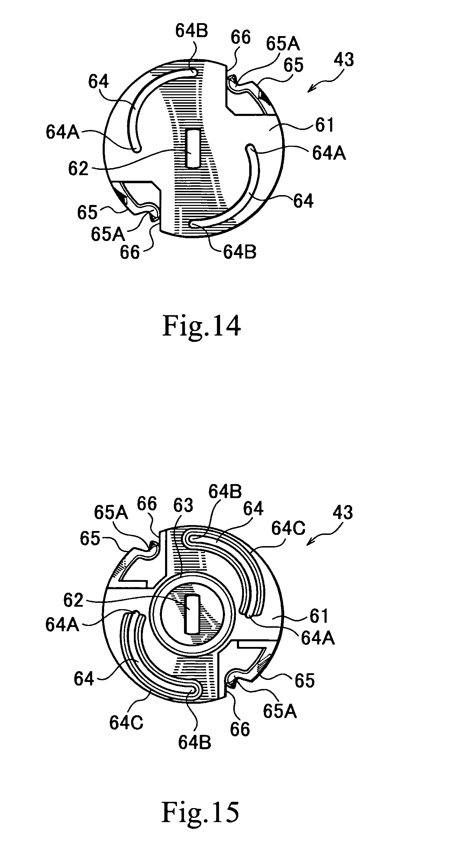

The feed member 43 is connected to latch member 42 to cause the latch member 42 to appear and disappear. The feed member 43 is rotatably attached to the rotating support shaft 36 of the recess 33. As shown in Figs. 7, 8, and 12 to 15, the feed member 43 includes a top plate 61, a key groove 62, the rotating cylinder portion 63, the long hole 64, and the latch piece 65.

The top plate 61 is substantially formed in a disk shape. Two notches 66 for providing the latch piece 65 are provided at positions opposite each other in the top plate 61 respectively.

The key groove 62 is the groove in which a latch key of a lid unit attaching and detaching device (not shown) is fitted when the manufacturing line lid unit 15 is automatically attached and detached by the lid unit attaching and detaching device. The key groove 62 is provided in the center of the upper surface of the top plate 61.

The rotating cylinder portion 63 is used when the feed member 43 is rotatably attached to the rotating support shaft 36 of the recess 33. The rotating cylinder portion 63 is provided at the central portion of the lower surface of the top plate 61. The key groove 62 is designed to be located in the center of the rotating cylinder portion 63.

The long hole 64 converts the rotation of the feed member 43 into the appearance and disappearance actions of the latch member 42. The two long holes 64 are provided at the positions opposite each other in the top plate 61 respectively. The long hole 64 is formed by a part of a spiral so that one end portion 64A of the long hole 64 is located near the center of the top plate 61 and the other end portion 64B is located far away from the center of the top plate 61. When the connecting shaft 51 of the latch member 42 is fitted in the end portion 64A of the long hole 64, the latch member 42 is pulled in. When the connecting shaft 51 of the latch member 42 is fitted in the end portion 64B of the long hole 64, the latch member 42 is fed.

A gentle slope 64C is provided in the lower surface of the top plate 61 in the long hole 64. The slope 64C is set such that the slope 64C is the same height as the lower surface of the top plate 61 at the end portion 64A of the long hole 64 and the height of the slope 64C is gradually increased toward the end portion 64B. This is because the latch member 42 and the feed member 43 are securely connected. That is, when the connecting shaft 51 of the latch member 42 is fitted in the end portion 64B of the long hole 64 to be fed, the base end portion of the latch member 42 is pushed down, so that the connecting shaft 51 is securely fitted in the long hole 64 even if the base end portion is pushed down.

The latch piece 65 holds the feed member 43 while the feed member 43 is rotated by the predetermined angle. The two latch pieces 65 are provided at positions opposite each other in the circumference of the top plate 61. The latch piece 65 is formed by the plate-shaped member extending along the circumference from the top plate 61. The projection 65A which is fitted in the holder 37A of the stopper 37 is provided in the leading end portion of the latch piece 65. The latch piece 65 has elasticity, and the latch piece 65 elastically holds the projection 65A. When the projection 65A is fitted in the holder 37A of the stopper 37, the feed member 43 is held while rotated by the predetermined angle (angle in which the latch member 42 is caused to extend to fix the manufacturing line lid unit 15 to the container main body 12).

The cam mechanism 44 fixes the manufacturing line lid unit 15 by engaging the upper surface of the second fitted portion 24 to push down the manufacturing line lid unit 15 onto the container main body 12 side while the leading-end fitting portion 56 of the latch member 42 fed by the feed member 43 is fitted in the second fitted portion 24 of the lid unit holder 21. While the cam mechanism 44 engages the upper surface of the second fitted portion 24 by pushing up the leading-end fitting portion 56 of the latch member 42 fed by the feed member 43, the cam mechanism 44 fixes the manufacturing line lid unit 15 by pushing down the base end portion to push down the manufacturing line lid unit 15 onto the container main body 12 side by the leverage principle. The cam mechanism 44 includes the base-end lower cam 39, the base-end upper cam 53, the base-end slide surface 52, the cam holder projection 69, the leading-end cam 40, and the leading-end slide surface 55A. The configurations of the base-end lower cam 39, the base-end upper cam 53, the base-end slide surface 52, the leading-end cam 40, and the leading-end slide surface 55A are already described above

The cam holder projection 69 engages the slope 53A of the base-end upper cam 53 to push down the base end portion of the latch member 42 when the latch member 42 is fed. The cam holder projection 69 is provided in the lower surface of the hold cover 45. Specifically, the cam holder projection 69 and the slope 53A of the base-end upper cam 53 are provided while the cam holder projection 69 slides to the slope 53A with no gap in the state in which the base-end slide surface 52 of the latch member 42 slides to the slope 39A of the base-end lower cam 39.

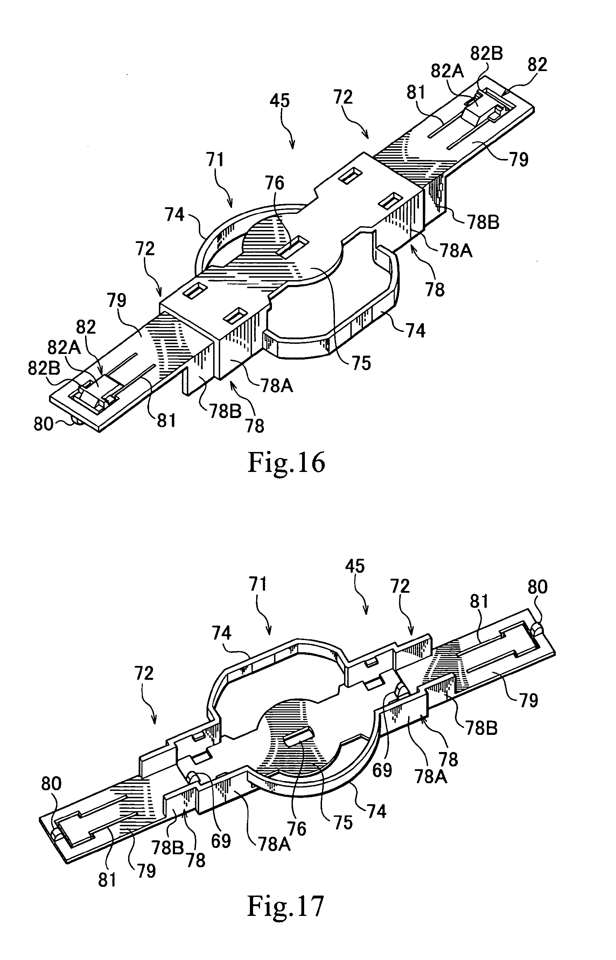

The hold cover 45 holds the latch member 42 and the feed member 43. As shown in Figs. 16 and 17, the hold cover 45 includes a feed-member holder 71 and a latch-member holder 72.

The feed-member holder 71 supports the feed member 43 while permitting the feed member 43 to be rotated. The feed-member holder 71 includes a circumferential plate 74 and a top plate 75. The circumferential plate 74 is formed while the circumference of the feed member 43 is covered with the circumferential plate 74. The top plate 75 is formed while the upper side of the feed member 43 is covered with the top plate 75. A key hole 76 whose size is equal to the key groove 62 of the feed member 43 is provided in the central portion of the top plate 75. The key hole 76 matches the key groove 62 of the feed member 43 while the feed member 43 is covered with the top plate 75. Therefore, the key groove 62 matches the key hole 76 while the latch member 42 is pulled in.

The latch member holder 72 supports the latch member 42 while permitting the latch member 42 to be reciprocally moved. The latch member holders 72 are provided on the right and left sides of the feed-member holder 71 respectively. Each latch member holder 72 includes a side plate 78 and a top plate 79.

The side plate 78 supports the latch member 42 from the right and left sides in the vicinity of the latch member 42. The side plate 78 includes a wide portion 78A and a narrow portion 78B. The base-end side-plate 57 of the latch member 42 is fitted in the wide portion 78A. The portion located between the base-end side-plate 57 and the leading-end side-plate 58 in the latch member 42 is fitted in the narrow portion 78B.

The top plate 79 supports the latch member 42 from the upper side. The cam holder projection 69 is provided in the base end portion of the lower surface of the top plate 79. A support projection 80 which is fitted in the upper groove 54 of the latch member 42 is provided in the leading end portion of the lower surface of the top plate 79. A slit 81 is provided on the leading end side of the top plate 79, and a projection 82 is provided in the leading end of the slit 81. The projection 82 includes a central projection piece 82A and latch piece 82B. The projection 82 is elastically supported by the slit 81. The positioning is performed between the hold cover 45 and the cover clamp 46 by fitting the central projection piece 82A and latch piece 82B of the projection 82 in a cross notch 86A of the cover clamp 46.

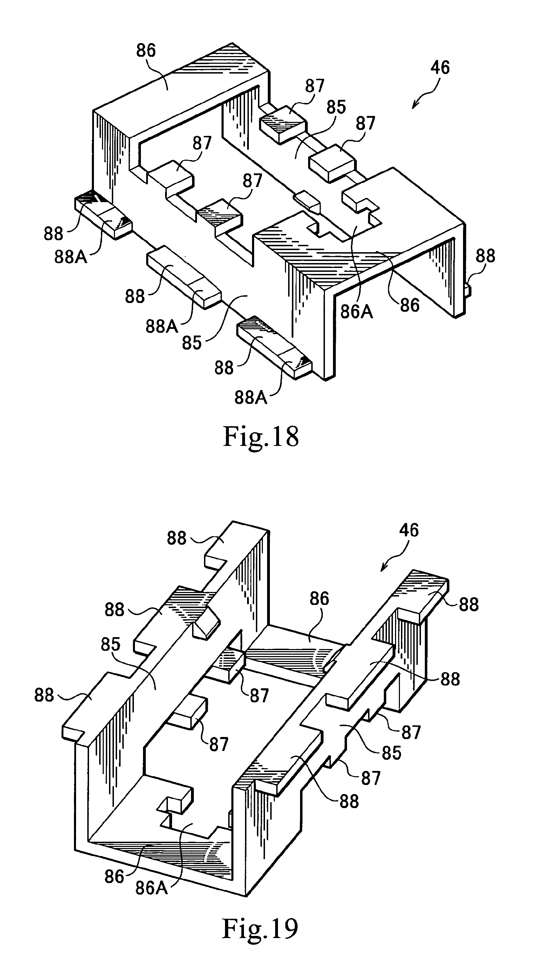

As shown in Figs. 8, 18, and 19, the cover clamp 46 fixes the hold cover 45 to the recess 33 of the manufacturing line lid unit 15. Specifically, the two cover clamps 46 support the latch member holders 72 to fix the hold cover 45 to the recess 33. The cover clamp 46 includes a side plate 85, a top plate 86, an upper support plate piece 87, and a lower support plate piece 88.

The right and left side-faces of the latch member 42 are covered with the side plates 85 so that the latch member 42 is permitted to be reciprocally moved. The top plate 86 integrally supports the side plates 85, and the upper side of the latch member 42 is covered with the top plate 86 to permit the latch member 42 to be reciprocallymoved. The upper support plate piece 87 supports the top plate 79 of the latch member holder 72 of the hold cover 45 from the lower side of the top plate 79. The top plate 79 of the latch member holder 72 is vertically supported by the top plate 86 of the cover clamp 46 and the upper support plate piece 87. The lower support plate piece 88 fixes the cover clamp 46 to the recess 33. Each three of the lower support plate pieces 88 are provided in the lower end portions of the side plates 85. The cover clamp 46 is fixed to the recess 33 by fitting the lower support plate pieces 88 in the latch pawls 38 provided in the recess 33 respectively. A taper 88A is provided in each lower support plate piece 88 so as to be easily fitted in the latch pawl 38.

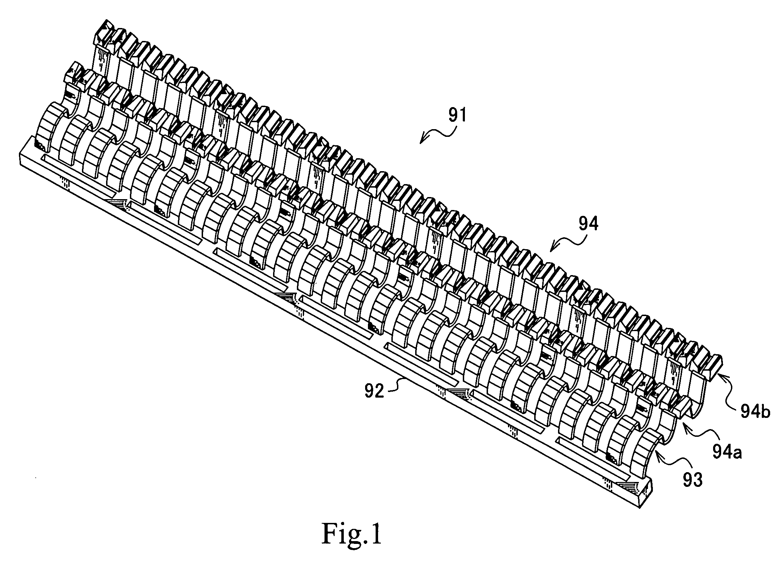

In lower surfaces of the transport lid unit 14 and the manufacturing line lid unit 15, as shown in Figs. 1, 20, and 21, a wafer retainer 91 is provided as a thin-plate retainer. The wafer retainer 91 supports the plural semiconductor wafers stored in the container main body 12 from the upper side of the semiconductor wafers. The wafer retainer 91 includes a base-end support portion 92, an elastic support plate 93, and an engaging piece 94.

The base-end support portion 92 supports the elastic support plate 93 and the engaging piece 94. The base-end support portion 92 is formed in a square bar across the total length of the wafer retainer 91, and the base-end support portion 92 is fixed to the lower surface of the lid unit.

The elastic support plate 93 elastically supports the engaging piece 94. The elastic support plates 93 are arranged according to the number of semiconductor wafers stored in the container main body 12. The elastic support plates 93 are fixed to the base-end support portion 92 while horizontally arranged in a row. The elastic support plate 93 includes a first support plate piece 93A whose side face is bent in an S-shape and a second support plate piece 93B whose side face is bent in a U-shape. In the first support plate piece 93A, the base end portion is fixed to the base-end support portion 92, and a first engaging piece 94A is fixed to the leading end portion. In the second support plate piece 93B, the base end portion is integrally connected to the first support plate piece 93A through the first engaging piece 94A, and a second engaging piece 94B is fixed to the leading end portion.

The elastic support plate 93 is set so that the range where the proportionality is held between the amount of displacement of the engaging piece 94 and the external force is set up to 1.5 to 2.5 mm. That is, the proportionality is held between the amount of displacement and the external force when the amount of displacement does not exceed the range of 1.5 to 2.5 mm. Hereinafter the amount of displacement in the range where the proportionality is held between the amount of displacement and the external force is referred to as an elastic displacement amount. When the engaging piece 94 is displaced beyond the elastic displacement amount, spring resistance force is rapidly increased. It is desirable that the elastic displacement amount is set to 1.5 mm. This is because the semiconductor wafer is elastically supported within the amount of the displacement of the semiconductor wafer to rapidly prevent the spring resistance force, even if the amount of displacement is increased as the semiconductor wafer is enlarged to 300 mm in the size. As described above, in the thin-plate supporting container, recently the molding accuracy is improved so that the existence position tolerance of the semiconductor wafer ranges from about -0.5 mm to about +0.5 mm. Therefore, in the amount of displacement not exceeding the elastic displacement amount ranging from 1.5 to 2.5 mm, the range of 0 to 0.5 mm is used for holding force of the semiconductor wafer (holding force for securing drop-resistant performance and vibration-resistant performance), and the range of 0.5 to 1.5 mm (2.5 mm at the maximum according to design) is used for permitting variations in existence position of the semiconductor wafer.

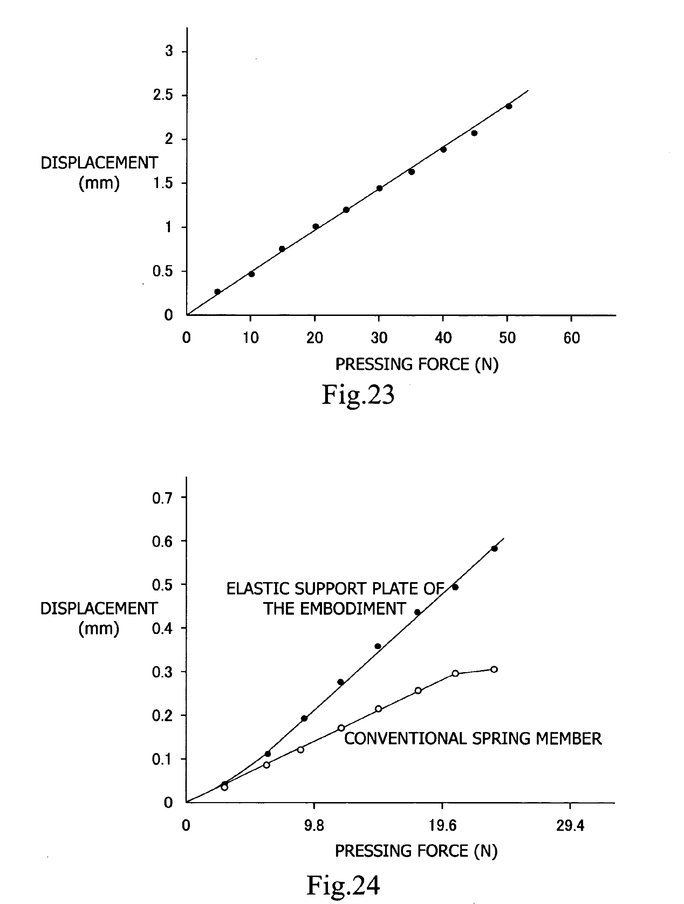

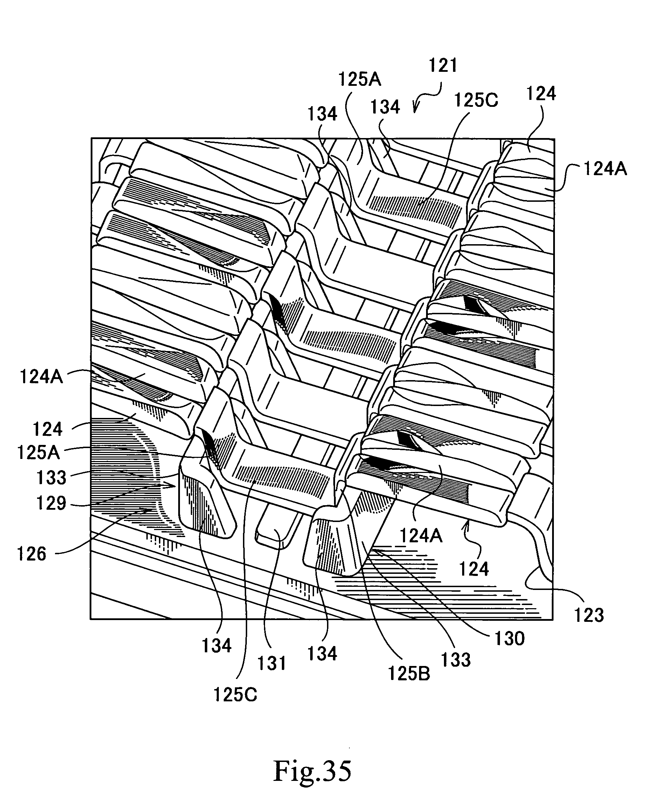

Figs. 23 and 24 show spring characteristics of the elastic support plate 93. Fig. 23 shows values per one semiconductor wafer, and Fig. 24 shows values per two semiconductor wafers. As shown in Fig. 23, the proportionality is held between the amount of displacement and pressing force up to the amount of displacement of 2.5 mm. Therefore, the elastic support plate 93 is elastically deformed in the range of 0 to 2.5 mm. When compared to the characteristics of the conventional spring, as shown in Fig. 24, the conventional spring member (lower line in Fig. 24) is hardly displaced when the pressing force becomes 0.3 mm. On the contrary, the elastic support plate 93 according to the first embodiment is deformed while the proportionality is held between the amount of displacement and the pressing force. As shown in Fig. 23, the proportionality is held up top the amount of displacement of 2.5 mm. In Figs. 23 and 24, the proportionality is held when the amount of displace exceeds 2 . 5 mm. However, like the conventional spring member, the elastic support plate 93 is designed so as to be hardly displaced when the maximum amount of displacement exceeds 2.5 mm. In the case of the structure in which a part of the elastic support plate (for example, a horizontal plate 125C in Fig. 35) engages the backsides of the lid units 14 and 15, it is possible that the size of the corresponding part is changed and designed so as to be hardly displaced when the maximum amount of displacement exceeds 2.5 mm.

Figs. 23 and 24 show the experimental results when the two semiconductor wafers are simultaneously pressed. In the elastic support plate 93 having the characteristics, the spring force becomes about 1 kg for one semiconductor wafer when the amount of displacement is 0.5 mm, and the spring force becomes about 3 kg when the amount of displacement is 1.5 mm. In the case where the 25 semiconductor wafers are stored, clamping force ranges from 25 to 75 kg.

In the state in which the manufacturing line lid unit 15 is lightly fitted in the container main body 12 and the force is not applied, the installation position of the engaging piece 94 supported by the elastic support plate 93 is set to the position where the engaging piece 94 is not in contact with the semiconductor wafers stored in the container main body 12 while the small gap is kept between the engaging piece 94 and the semiconductor wafers, or the installation position of the engaging piece 94 is set to the position where the engaging piece 94 is in slight contact with the semiconductor wafers. Therefore, when the manufacturing line lid unit 15 is fitted in and fixed to the container main body 12, even if the container main body 12 is not fixed to press the manufacturing line lid unit 15, the manufacturing line lid unit 15 is fitted in the container main body 12 so as to be able to fix the manufacturing line lid unit 15 only by rotating the latch key, which results in facilitating automatization of the easy attachment and detachment of the manufacturing line lid unit 15.

The engaging piece 94 directly supports each of the semiconductor wafers. Each engaging piece 94 has the first engaging piece 94A and the second engaging piece 94B, and the semiconductor wafer is supported at two points. The engaging piece 94 includes two blocks 96 and a support pawl 97 alternately arranged.

The block 96 includes a slope 96A and an engaging surface 96B. In order to easily insert the peripheral portion of the semiconductor wafer between the two blocks 96, the slope 96A is formed so as to open outward while the two blocks 96 are formed opposite each other. The engaging surface 96B is configured so as to form the groove having a constant width (slightly wider than the thickness of the semiconductor wafer) when the two blocks 96 are attached opposite each other.

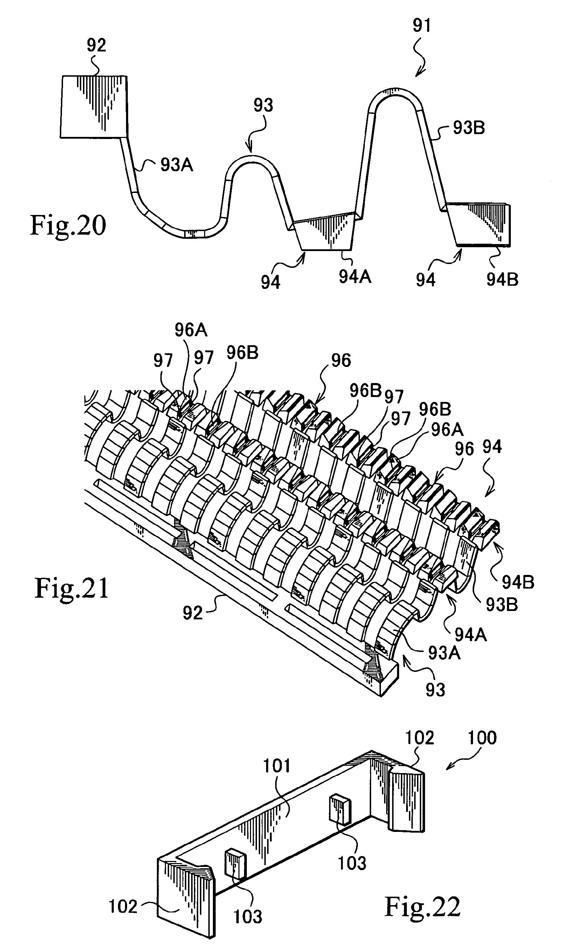

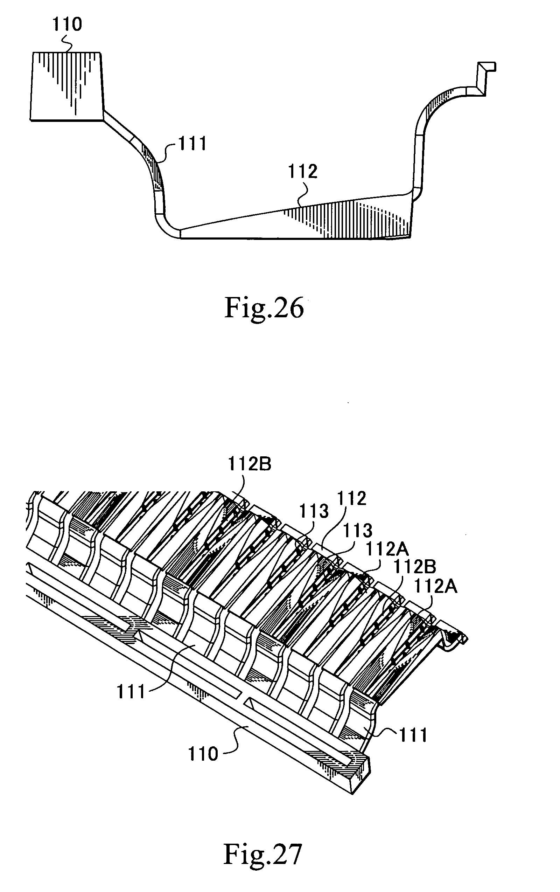

The support pawl 97 (the same member as the support pawl 113 in Fig. 27) comes into direct contact with the peripheral portion of the semiconductor wafer to support the semiconductor wafer. The support pawl 97 is provided in the engaging surface 96B of each block 96. The support pawl 97 is formed by a long convex strip. The support pawls 97 are alternately arranged in the opposite engaging surface 96B. Specifically, two support pawls 97 are provided at the both end in one of the engaging surfaces 96B and one support pawl 97 is provided in the center of the other engaging surface 96B, which allows the support pawls 97 opposite each other to be alternately arranged. That is, in the block 96 on the upper left side of the two blocks 96 opposite each other in the engaging piece 94 of Fig. 21, two support pawls 97 are provided at the both end portions in the upper right and lower left directions of the engaging surface 96B. Further, one support pawl 97 is provided in the center of the engaging surface 96B in the block 96 on the lower right side. Therefore, the support pawls 97 opposite each other are alternately arranged.

The support pawl 97 is molded with an elastic material, and the support pawl 97 elastically supports the peripheral portion of the semiconductor wafer. The gap between two engaging surfaces 96B is slightly wider than the thickness of the semiconductor wafer, so that the gap between two leading ends of the support pawls 97 arranged in the engaging surfaces 96B is narrower than the thickness of the semiconductor wafer. Therefore, the semiconductor wafer is inserted between the support pawls 97 while slightly pushing the support pawls 97 made of the elastic material which are alternately arranged. Therefore, the peripheral portion of the semiconductor wafer is securely supported by the alternately arranged support pawls 97.

As shown in Fig. 22, a lid unit holder 100 is provided outside the manufacturing line lid unit 15. The lid unit holder 100 prevents the manufacturing line lid unit 15 from detaching from the container main body 12. The lid unit holder 100 includes a support plate 101, a hook 102, and a fitting projection 103.

The support plate 101 supports the hook 102 and the fitting projection 103. The hooks 102 are provided at the both end portions of the support plate 101 respectively. The flange portion of the container main body 12 (the flange portion and the like outside the lid unit holder 21 in Fig. 3) is hooked on the hook 102.

The fitting projection 103 is provided in one side surface of the support plate 101. The fitting projection 103 is formed in the same shape as the key groove 62, and the fitting projection 103 is fitted in the key groove 62 through the key hole 76. The two fitting projections 103 are provided at positions in which the two fitting projections 103 match the two key grooves 62 respectively. Therefore, each fitting projection 103 is fitted in each key groove 62 to fix the feed member 43 while the flange of the container main body 12 is hooked on the hook 102. This is because that the vibration and the shock rotate the feed member 43 to release the fixation of the manufacturing line lid unit 15 to the container main body 12 is prevented during the transport of the thin-plate supporting container.

The thin-plate supporting container 11 having the above configuration is used as described below.

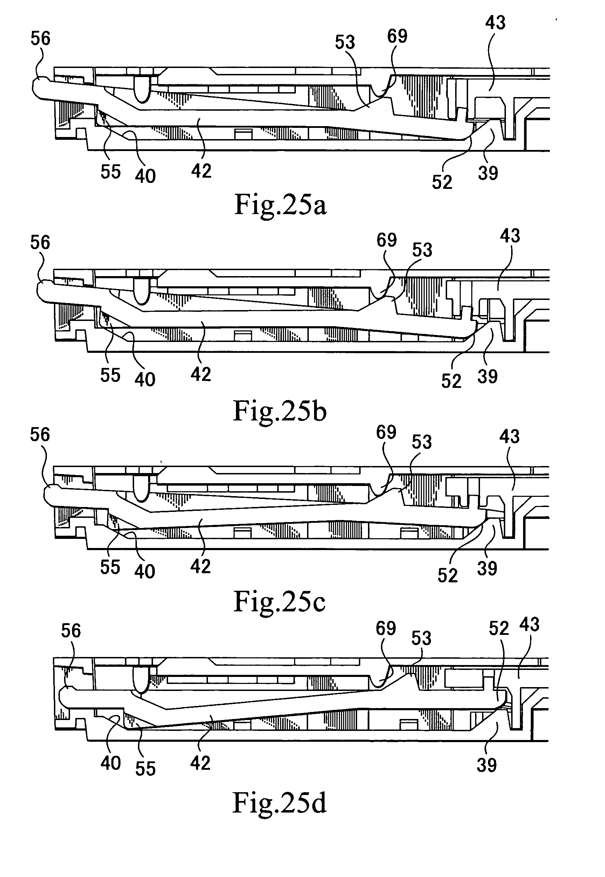

When the manufacturing line lid unit 15 is detached from the container main body 12, the latch key is fitted in the key groove 62 and rotated, which allows the feed member 43 to be rotated from the state shown in Fig. 25A to gradually pull in the latch member 42. Therefore, the leading-end slide surface 55A of the fulcrum portion 55 in the latch member 42 slides to the slope 40A of the leading-end cam 40 to push down the leading-end fitting portion 56 as shown in Figs. 25B, 25C, and 25D. At the same time, the base-end slide surface 52 of the latch member 42 slides to the slope 39A of the base-end lower cam 39 to push up the base end portion of the latch member 42. Therefore, the leading-end fitting portion 56 is completely stored in the main body 30. Then, the manufacturing line lid unit 15 is detached from the container main body 12.

When the manufacturing line lid unit 15 is attached to the container main body 12, the manufacturing line lid unit 15 supported by the latch key fitted in the key groove 62 is attached to the lid unit holder 21, which allows the manufacturing line lid unit 15 to be fitted without applying any particular force until the gasket 22 of the transport lid unit 14 engages the sealing groove 21C. In this state, the bottom portion of the engaging piece 94 of the wafer retainer 91 is not in contact with the semiconductor wafer, or the bottom portion of the engaging piece 94 is in slight contact with the semiconductor wafer. The leading-end fitting portion 56 of the latch member 42 in the simplified detaching mechanism 32 is positioned inside the engaging surface of the second fitted portion 24 (inside the container main body 12). In this state, the latch key is rotated. Therefore, contrary to the case in which the manufacturing line lid unit 15 is detached from the container main body 12, the latch member 42 is pushed out from the main body 30, and the leading-end fitting portion 56 is smoothly fitted in the second fitted portion 24 to engage the engaging surface of the second fitted portion 24. At this point, the fulcrum portion 55 of the latch member 42 slides the slope 40A of the leading-end cam 40 to push up the leading-end fitting portion 56. Further, the cam holder projection 69 slides the slope 53A of the base-end upper cam 53 to push down the base end portion of the latch member 42. Therefore, the base-end slide surface 52 of the latch member 42 is pushed down along the slope 39A of the base-end lower cam 39.

In the fulcrum portion 55 of the latch member 42, the leading-end slide surface 55A is fitted in the fitting recess 40B, and the latch member 42 is rotated about the fitting recess 40B.

In the base end portion of the latch member 42, while the base-end slide surface 52 slides to the slope 39A of the base-end lower cam 39, the cam holder projection 69 engages the slope 53A of the base-end upper cam 53 to push down the base end portion of the latch member 42.

Therefore, the latch member 42 acts as the lever in which the fulcrum portion 55 fitted in the fitting recess 40B becomes the fulcrum, and the manufacturing line lid unit 15 is fixed by strongly pushing the manufacturing line lid unit 15 down onto the container main body 12 side while the leading-end fitting portion 56 is fitted in the second fitted portion 24 of the lid unit holder 21. Accordingly, the engaging piece 94 of the wafer retainer 91 is fitted in the semiconductor wafer to support the semiconductor wafer. At this point, a rotating torque of the latch key is transmitted to the latch and converted into push-out force of the latch member 42. Then, the latch member 42 engages the container main body 12 to convert the push-out force into the force pressing the manufacturing line lid unit 15 against the container main body 12 and the force pressing the wafer retainer 91 against the semiconductor wafers. The force pushed back from the semiconductor wafers returns to the manufacturing line lid unit 15. Therefore, even if the container main body 12 is not fixed, the lid unit 15 can be attached and detached without shifting the container main body 12 by the force generated when the latch key is rotated.

In the state in which the manufacturing line lid unit 15 is attached to the container main body 12, the lid unit holder 100 is attachedas necessary. Specifically, the flange portion of the container main body 12 (the flange portion and the like outside the lid unit holder 21 in Fig. 3) is hooked on the hook 102. Therefore, the fitting projection 103 is fitted in the key groove 62 to fix the feed member 43.

In the container main body 12, the peripheral portion of the semiconductor wafer is fitted in the engaging piece 94. In the engaging piece 94, the peripheral portion of the semiconductor wafer is inserted between the alternately arranged support pawls 97, and the semiconductor wafer is securely supported by the support pawls 97.

When the strong shock is applied from the outside of the thin-plate supporting container 11, the latch member 42 strongly presses the manufacturing line lid unit 15 against the container main body 12 using the leverage principle, so that the manufacturing line lid unit 15 is never detached from the container main body 12. Further, since the feed member 43 is fixed by the lid unit holder 100, there is no possibility that the latch member 42 is detached from the second fitted portion 24 by rotating the feed member 43.

On the other hand, since the semiconductor wafer in the thin-plate supporting container 11 is fitted in the engaging piece 94 of wafer retainer 91 and supported by the alternately arranged support pawls 97 from the both sides, there is no possibility that the semiconductor wafer is detached from the engaging piece 94 by rotating the feed member 43. Further, the engaging piece 94 is supported by the elastic support plate 93, so that the first support plate piece 93A and the second support plate piece 93B engage the lower surface of the manufacturing line lid unit 15 by their own elastic force to support the semiconductor wafer, which enables the breakage of the semiconductor wafer to be prevented.

At this point, the engaging piece 94 supported by the elastic support plate 93 supports the semiconductor wafer up to the amount of displacement of about 0.5 mm. Further, while the engaging piece 94 securely supports the semiconductor wafer by absorbing the position shift of the semiconductor wafer up to the amount of displacement of about 1.5 mm (2.5 mm at the maximum depending on the design), the engaging piece 94 absorbs the vibration and shock from the outside by the elastic displacement up to the amount of displacement of about 1.5 mm (2.5 mm at the maximum depending on the design). For the large shock and the like, the shock is absorbed at a first stage in which the engaging piece 94 is elastically displaced up to the amount of displacement of about 1.5 mm (2.5 mm at the maximum depending on the design). When the elastic displacement exceeds 2.5 mm, the shock is absorbed at a second stage in which the spring resistance force is rapidly increased by the characteristics previously set to the elastic support plate 93.

In the case of cleaning, when the cover clamp 46 is shifted to detach the cover clamp 46 from the latch pawls 38, the simplified detaching mechanism 32 is disassembled into the latch member 42, the feed member 43, the cam mechanism 44, the hold cover 45, and the cover clamp 46, and each part can individually be cleaned and dried.

As described above, according to the thin-plate supporting container 11, the following effects can be obtained.
(1) The maximum amount of displacement of the wafer retainer 91 is set to 1.5 mm (2.5 mm at the maximum depending on the design). Therefore, even in the semiconductor wafer having the diameter of 300 mm, the thin-plate supporting container 11 can support the semiconductor wafers by absorbing the increase in displacement amount associated with the enlargement of the semiconductor wafer size, and the spring resistance force can be prevented from rapidly increasing.
(2) The proportionality is held between the amount of displacement and the external force in the range not exceeding the maximum amount of displacement of the wafer retainer 91 of 1.5 mm (2.5 mm at the maximum depending on the design). Therefore, the spring resistance force of the wafer retainer 91 is not rapidly increased, and the thin-plate supporting container which is excellent for the vibration-resistant performance and shock-resistant performance can be provided.
   When the large shock is applied to the thin-plate supporting container, the shock is absorbed at the first stage in which the engaging piece is elastically deformed up to the maximum amount of displacement of about 1.5 mm (2.5 mm at the maximum depending on the design), and the shock is absorbed at the second stage in which the spring resistance force is rapidly increased when the elastic displacement exceeds 2.5 mm. Therefore, the shock from the outside can be absorbed without applying the large shock to the semiconductor wafer.
(3) In the state in which the manufacturing line lid unit 15 is slightly fitted in the container main body 12, the wafer retainer 91 is not in contact with the semiconductor wafer, or the wafer retainer 91 is in light contact with the semiconductor wafer. Therefore, the semiconductor wafer can be fixed to container main body 12 without strongly pressing the manufacturing line lid unit 15, and the automatization of the attachment and detachment of the manufacturing line lid unit 15 can be easily realized.
(4) The latch member 42 is fed using the leverage principle, so that the manufacturing line lid unit 15 can be firmly fixed to the container main body 12 with the strong force.
(5) The simplified detaching mechanism can be taken apart into component parts. Therefore, in the case of the cleaning, while the simplified detaching mechanism can be taken apart into component parts to clean every part, the component parts can be immediately dried.
(6) The support pawls 97 are alternately arranged, so that the semiconductor wafer can securely be supported by alternately engaging the support pawl 97 to the circumference of the semiconductor wafer.

### Second Embodiment

Then, a second embodiment of the invention will be described. In the second embodiment, the wafer retainer is improved.

Sometimes the thin-plate supporting container is vibrated by various factors during transport. When the vibration is transmitted to the semiconductor wafer, sometimes the undesirable rotation of the semiconductor wafer is generated by the vibration. Therefore, when the thin-plate supporting container is used in the mode in which the thin-plate supporting container is subject to the vibration, the wafer retainer according to the second embodiment (thin-plate retainer) is used. Referring to Figs. 35 to 44, a wafer retainer 121 of the second embodiment will be described below. Because the constituents except for the wafer retainer 121 are similar to those of the thin-plate supporting container 11 of the first embodiment, the similar constituent is indicated by the same reference numeral, and the description is neglected.

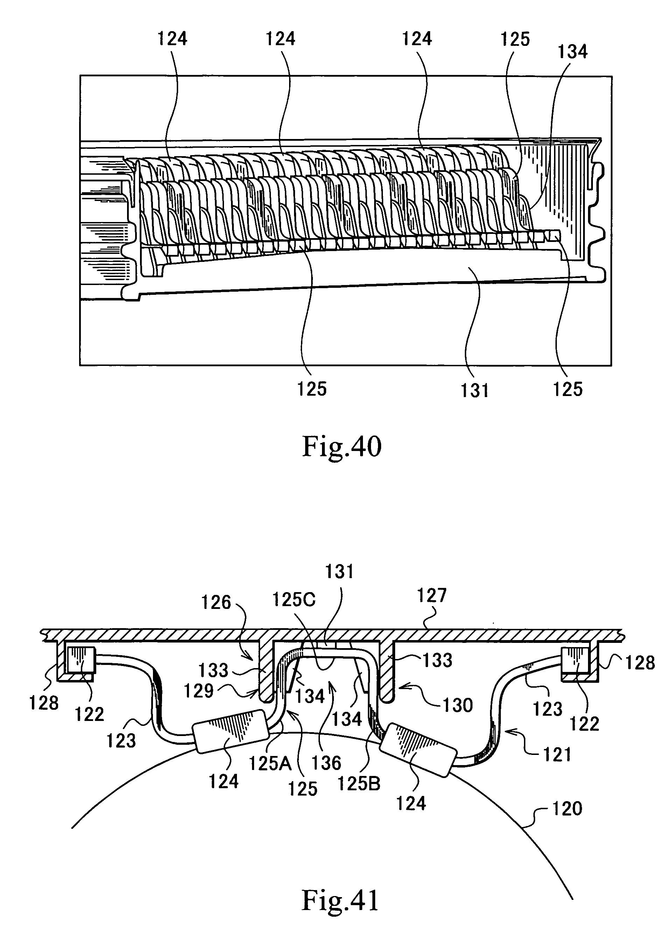

As shown in Fig. 41, the wafer retainer 121 includes a base-end support portion 122, an elastic support plate 123, an engaging piece 124, a connecting support plate 125, and a support rib 126.

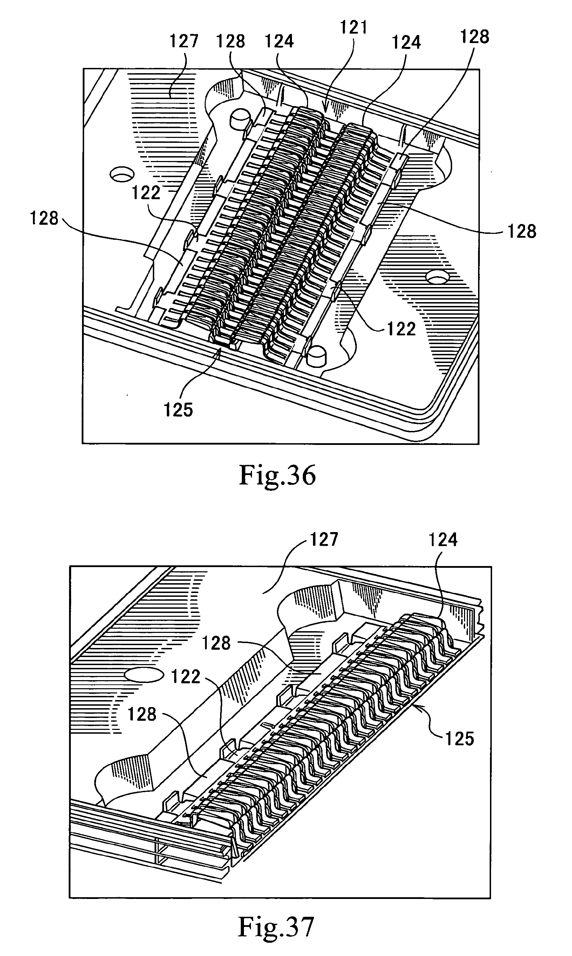

The base-end support portions 122 are respectively provided at the both end of the wafer retainer 121 to directly support the two elastic support plates 123. The base-end support portion 122 is formed in the square bar across the total length in the longitudinal direction of the wafer retainer 121 (vertical direction in Fig. 36). Twohook-shaped support portions 128 are provided on the lower side of a lid unit 127 respectively. The base-end support portions 122 are respectively fitted in the hook-shaped support portions 128 and fixed to the backside of the lid unit 127.

The elastic support plate 123 elastically supports the outside end of the engaging piece 124. Two sets of elastic support plates 123 are arranged according to the number of semiconductor wafers 120 stored in the container main body 12. The elastic support plates 123 are fixed to the base-end support portion 122 while horizontally arranged in a row. In the elastic support plate 123, the side face is bent in the S-shape. In the two sets of elastic support plates 123, the base end portions are fixed to the two base-end support portions 122 respectively, and each engaging piece 124 is attached to the leading end portion, which elastically supports the engaging pieces 124.

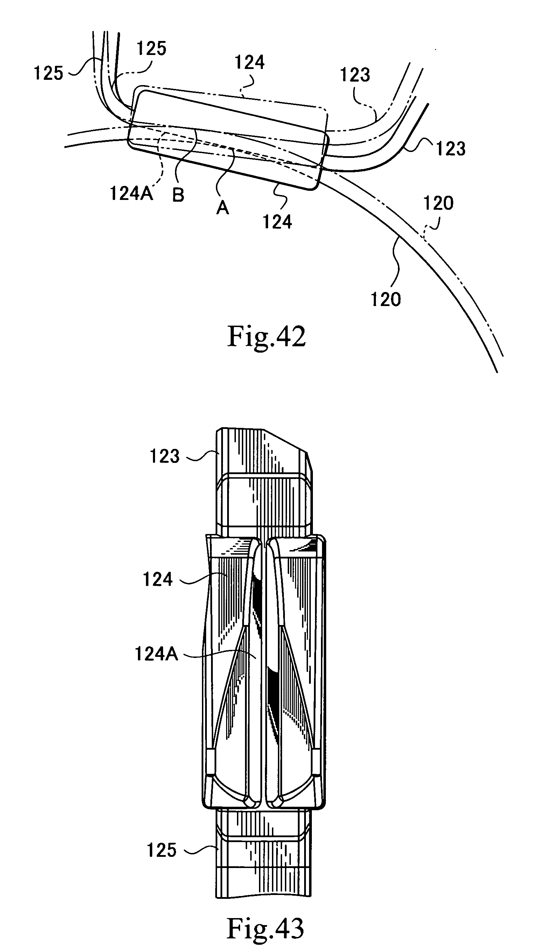

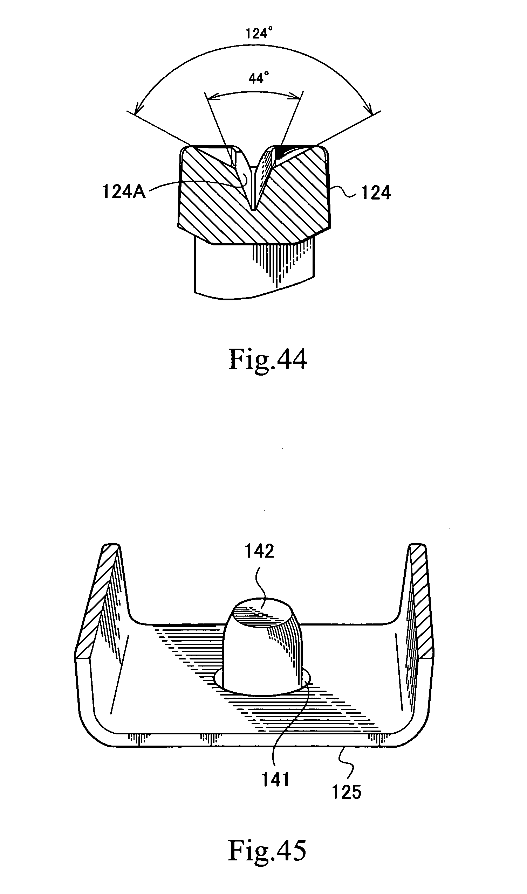

The engaging piece 124 directly engages the circumferential portion of each semiconductor wafer 120 to directly support the semiconductor wafer 120. As shown in Figs. 43 and 44, a V-shaped fitting groove 124A in which the semiconductor wafer 120 is fitted is provided in one of side faces of each engaging piece 124. The fitting groove 124A is formed in the V-shape having the two stages. In the first-stage groove, the gentle slope having an angle of 124° is formed. In the second-stage groove, the slope having the angle of 44° is formed. Therefore, when the circumference of the semiconductor wafer 120 comes into contact with the first-stage groove, the circumference of the semiconductor wafer 120 is guided by the gentle slope to fall down in the second-stage groove, and the semiconductor wafer 120 is supported by the second-stage groove. The bottom portion of the second-stage groove is formed in a flat whose width is substantially equal to the thickness of the semiconductor wafer 120. The slope angle and the bottom width of the second-stage groove are formed according to the size of the peripheral portion of the semiconductor wafer 120. Because the peripheral portion of the semiconductor wafer 120 is cut at an edge angle of 44°, the slope angle of the groove is set to 44°. Further, the bottom width of the groove is also set according to the width of the peripheral portion of the semiconductor wafer 120, which allows the second-stage groove to firmly hold the semiconductor wafer 120. Therefore, the second-stage groove securely supports the semiconductor wafer 120 while being in contact with the semiconductor wafer 120 in the wide area, and the semiconductor wafer 120 can be prevented from rotating against the vibration. Although the second-stage groove is set to 44° according to the edge angle of the semiconductor wafer 120, in consideration of the material of the engaging piece 124, it is also possible that the second-stage groove is formed in the slope angle slightly narrow than 44°. Specifically, the slope angle is appropriately set in the range of about 40° to about 44° according to difference in elastic force. When the slope angle of the second-stage groove is too narrow, the peripheral portion of the semiconductor wafer 120 is not sandwiched. Therefore, when the lid unit 127 is lifted up, sometimes the semiconductor wafer 120 is lifted up in conjunction with the lid unit 127, so that the slope angle is set to a certain extent in which the semiconductor wafer 120 is sandwiched. In the case where the edge angle of the semiconductor wafer 120 is different from 44°, or in the case of other thin plates except for the semiconductor wafer 120, the slope angle of the second-stage groove is set in the range of about 20° to about 60° as appropriate.

As shown in Figs. 41 and 42, the bottom portion of the fitting groove 124A is set to the angle along the peripheral shape of the semiconductor wafer 120, i.e. such that the angle becomes a tangential direction of the periphery of the semiconductor wafer 120. As mentioned later, because the elastic force is increased in proportion to the amount of deformation of the wafer retainer 121, the force in which each engaging piece 124 presses the semiconductor wafer 120 is equalized as a whole. That is, when the amount of change is increased in one of the two engaging pieces 124, the elastic force is increased according to the amount of change, the semiconductor wafer 120 is slightly pushed onto the other engaging piece 124 side, and the semiconductor wafer 120 is settled at a point in which the elastic forces of the two engaging pieces 124 become equal to each other. As a result, the two engaging pieces 124 are automatically adjusted so that the elastic forces of the two engaging pieces 124 become equal to each other. Further, in the state in which the lid unit 127 is attached to the container main body 12, the bottom portion of the fitting groove 124A is set so as to come into contact with the semiconductor wafer 120 at the position near the substantial center of the bottom portion (contact point A in Fig. 42).

The connecting support plate 125 supports the two engaging pieces 124 while connecting the two engaging pieces 124. The both end portions of the connecting support plate 125 are respectively connected to the engaging pieces 124 to elastically support each engaging piece 124. The connecting support plate 125 is formed while the side face is bent in the U-shape. Specifically, the connecting support plate 125 includes vertical plates 125A and 125B located on the both sides and the horizontal plate 125C. The vertical plates 125A and 125B are arranged in the direction perpendicular to the backside of the lid unit 127, and the vertical plates 125A and 125B support the engaging pieces 124 respectively.

The horizontal plate 125C is configured to be elastically deformed. The horizontal plate 125C mainly assumes the function in which the connecting support plate 125 elastically supports the engaging piece 124. The horizontal plate 125C is arranged in the direction along the backside of the lid unit 127 while the vertical plates 125A and 125B are connected to the both ends respectively. The horizontal plate 125C is supported by the later-mentioned support convex strip 131 at the center, and the both end portions of the horizontal plate 125C are deformed centering the support convex strip 131.

The elastic force which is generated by the deformation of the horizontal plate 125C (elastic force by which the connecting support plate 125 supports the engaging piece 124) is set stronger than the elastic force by which the elastic support plate 123 supports the engaging piece 124. Therefore, in the two engaging pieces 124, the inside ends of the engaging pieces 124 are supported by the strong elastic force, and the outside ends of the engaging pieces 124 are supported by the weak elastic force. Further, as mentioned above, the bottom portions of the fitting grooves 124A in the two engaging pieces 124 are arranged in the tangential direction of the periphery of the semiconductor wafer 120. Accordingly, the force by which the wafer retainer 121 supports the semiconductor wafer 120 is set so as to increase in proportional to the amount of movement (vibration) of the semiconductor wafer 120. That is, in the normal state, as shown by solid lines in Fig. 42, the semiconductor wafer 120 is supported while being in contact with the bottom portion of the fitting groove 124A at the position near the central portion of the bottom portion (contact point A in Fig. 42). When the semiconductor wafer 120 is vibrated, the inside end of the engaging piece 124 supported by the strong elastic force of the connecting support plate 125 is not changed so much, and the outside end supported by the weak elastic force of the elastic support plate 123 is largely changed. Therefore, as shown by chain double-dashed lines in Fig. 42, the semiconductor wafer 120 is supported while moved onto the inside end side (contact point B side in Fig. 42) of the bottom portion in the fitting groove 124A. When the amount of vibration of the semiconductor wafer 120 is small (the amount of deformation of the wafer retainer 121 is small), the semiconductor wafer 120 is supported by the weak elastic force while being in contact with the bottom portion of the fitting groove 124A on the outside end side (contact point side A in Fig. 42). When the amount of vibration of the semiconductor wafer 120 is large (the amount of deformation of the wafer retainer 121 is large), the semiconductor wafer 120 is supported by the strong elastic force while the contact point of the semiconductor wafer 120 is moved onto the inside end side of the fitting groove 124A (contact point B side in Fig. 42). Further, as the amount of movement of the contact point of the semiconductor wafer 120 on to the inside end side is increased, the force applied to the connecting support plate 125 becomes larger than the force applied to the elastic support plate 123, and the elastic force is increased, which allows the vibration of the semiconductor wafer 120 to be efficiently suppressed.

The support rib 126 supports the connecting support plate 125 to prevent the connecting support plate 125 from shifting toward the direction along the backside of the lid unit. As shown in Figs. 35 to 41, the support rib 126 is provided in the central portion of the backside of the lid unit 127. The support rib 126 is provided such that the whole of many connecting support plates 125 of the wafer retainer 121 is covered. Specifically, the support rib 126 is set to the length in which the connecting support plates 125 arranged according to the number of stored semiconductor wafer 120 can be fitted. The support rib 126 includes two support walls 129 and 130.

The support walls 129 and 130 are provided in parallel while being opposite each other. Each of the support walls 129 and 130 includes a support plate piece 133 and a partition plate piece 134.

The support plate piece 133 supports the vertical plates 125A and 125B of the connecting support plate 125 so that the vertical plates 125A and 125B do not shift in a circumferential direction (horizontal direction in Fig. 41) of the semiconductor wafer 120. The support plate piece 133 directly supports the vertical plates 125A and 125B of the connecting support plate 125. Therefore, the support plate piece 133 indirectly supports the engaging pieces 124 so that the engaging pieces 124 do not shift in the circumferential direction of the semiconductor wafer 120.

The partition plate piece 134 is a plate piece which individually partitions the many connecting support plates 125. Each of the partition plate pieces 134 is provided while positioned on the outermost sides and between the connecting support plates 125, which allows the connecting support plate 125 to be supported from the both sides in the width direction by the partition plate pieces 134. The partition plate pieces 134 directly support the connecting support plate 125. Therefore, the partition plate pieces 134 indirectly support the engaging pieces 124 so that the engaging pieces 124 do not shift in the direction orthogonal to the circumferential direction of the semiconductor wafer 120.

The connecting support plate 125 is individually supported while sandwiched from the surrounding (radial direction of the semiconductor wafer 120 stored in the container main body 12) by the support plate piece 133 and the partition plate piece 134. Therefore, the connecting support plate 125 is prevented from shifting in the direction along the backside of the lid unit, and the movement in the direction perpendicular to the backside of the lid unit is permitted.

A slight gap is formed between the support plate piece 133 and partition plate piece 134 and the connecting support plate 125. That is, when the semiconductor wafer 120 is slightly vibrated, the connecting support plate 125 does not come into contact with the support plate piece 133 and partition plate piece 134, but the connecting support plate 125 is deformed to absorb the vibration. When the vibration violent, since the connecting support plate 125 is also violently vibrated through the engaging pieces 124, the connecting support plate 125 is supported while being in contact with the support plate piece 133 and partition plate piece 134.

As shown in Figs. 35 and 38 to 40, the support convex strip 131 is provided between the two support walls 129 and 130 of the support rib 126. The support convex strip 131 directly engages the connecting support plates 125 to support the connecting support plates 125. Specifically, the central portions of the horizontal plates 125C of the connecting support plates 125 engage the support convex strip 131 to support the connecting support plates 125, and the both end portions of the horizontal plate 125C can be freely deformed. The support convex strip 131 is provided at the central portion between the two support walls 129 and 130 which are provided in parallel while being opposite each other. The support convex strip 131 is provided in parallel with the support walls 129 and 130, and the support convex strip 131 has the substantially same length as the support walls 129 and 130.

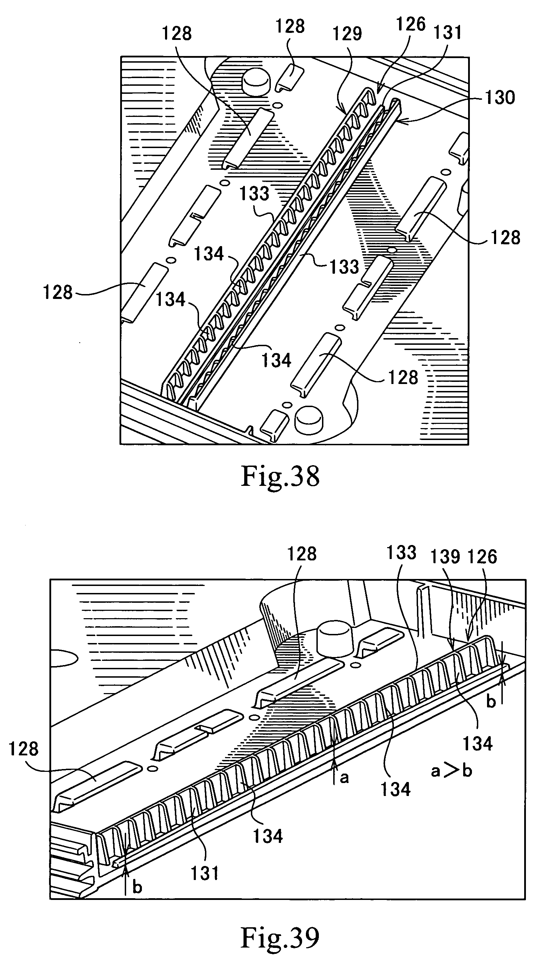

The support convex strip 131 has the configuration shown in Figs. 39 and 40. That is, the support convex strip 131 is molded so that the both-side portions (b in Fig. 39) are thin and the central portion (a in Fig. 39) is thick. Therefore, the engaging pieces 124 located in the central portion are projected toward the semiconductor wafer 120 further than the engaging pieces 124 located in the both sides. In the second embodiment, the support convex strip 131 is formed in a bow shape. In the state in which the wafer retainer 121 is attached to the lid unit 127, as shown in Fig. 40, the interval between the support convex strip 131 and the connecting support plate 125 becomes widened in the both sides, and the interval becomes narrowed in the central portion. The specific dimensions of the support convex strip 131 are appropriately set according to the amount of deformation of the lid unit 127.

The reason why the support convex strip 131 is formed in the above-described manner is as follows. When the lid unit 127 is attached while the plural semiconductor wafers 120 are stored in the container main body 12, a certain repellent force acts on the lid unit 127. The wafer retainer 121 attached to the backside of the lid unit supports each of the semiconductor wafers 120 one by one with a constant force. Therefore, as the diameter of the semiconductor wafer 120 is enlarged to increase the force supporting the semiconductor wafer 120, or as the number of semiconductor wafers 120 is increased, the repellent force pushing back the wafer retainer 121 is increased. The lid unit 127 to which the wafer retainer 121 is attached is slightly deformed toward the outside by the repellent force. When the lid unit 127 is deformed toward the outside, the force supporting the semiconductor wafers 120 with the wafer retainer 121 is weakened in the central portion. Therefore, the support convex strip 131 is provided in order to eliminate the unevenness of the force supporting the semiconductor wafers 120. The deformation of the lid unit 127 is absorbed by the support convex strip 131 in which the central portion is thick, and the wafer retainer 121 supports the semiconductor wafers 120 with even forces.

As with the first embodiment, in the wafer retainer 121, the range where the proportionality is held between the amount of displacement of the engaging piece 124 and the external force is set up to 1.5 to 2.5 mm. It is desirable that the maximum amount of displacement is set to 1.5 mm. In the amount of displacement not exceeding the maximum amount of displacement ranging from 1.5 to 2.5 mm, the range of 0 to 0.5 mm is used for the holding force of the semiconductor wafer (holding force for securing the drop-resistant performance and the vibration-resistant performance), and the range of 0.5 to 1.5 mm (2.5 mm at the maximum according to design) is used for permitting the variations in existence position of the semiconductor wafer.

In the state in which the lid unit 127 is lightly fitted in the container main body 12 and the force is not applied, the installation position of the engaging piece 124 is set to the position where the engaging piece 124 is not in contact with the semiconductor wafers stored in the container main body 12 while the small gap is kept between the engaging piece 124 and the semiconductor wafers, or the installation position of the engaging piece 124 is set to the position where the engaging piece 124 is in slight contact with the semiconductor wafers.

The thin-plate supporting container having the above configuration is used as follows.

When the lid unit 127 is attached while the plural semiconductor wafers 120 are stored in the container main body 12, the wafer retainer 121 is fitted in the semiconductor wafers 120.

When the lid unit 127 is attached to the container main body 12, as with the first embodiment, the lid unit 127 supported by the latch key fitted in the key groove 62 is attached to the lid unit main body 12, which allows the lid unit 127 to be fitted in the container main body 12 without applying any particular force. In this state, the wafer retainer 121 is not completely fitted in the semiconductor wafers 120, and the bottom portion of the wafer retainer 121 is not in contact with the semiconductor wafers 120 or the bottom portion of the wafer retainer 121 is in slight contact with the semiconductor wafers 120. The leading-end fitting portion 56 of the latch member 42 in the simplified detaching mechanism 32 is positioned inside the engaging surface of the second fitted portion 24 (inside the container main body 12). In this state, as with the first embodiment, the latch key is rotated, which allows the lid unit 127 to be pushed in the container main body 12 and fixed. Therefore, the wafer retainer 121 is completely fitted in the semiconductor wafers 120.

Specifically, the peripheries of the semiconductor wafers 120 are individually fitted in the fitting grooves 124A of the engaging pieces 124 to guide the peripheries of the semiconductor wafers 120 to the bottom portions of the fitting grooves 124A. At this point, when a marginal portion of the semiconductor wafer 120 is fitted in the second-stage groove, the second-stage groove securely supports the semiconductor wafer 120 while grasping the marginal portion of the semiconductor wafer 120 to come into contact with the semiconductor wafer 120 in the broad area. The engaging piece 124 is supported by the elastic support plate 123 and the connecting support plate 125.

The leading-end portion of the elastic support plate 123 elastically supports the outside end of the engaging piece 124 while the base-end portion of the elastic support plate 123 is supported by the base-end support portion 122 fixed to the backside of the lid unit 127. The both-side end portions of the connecting support plate 125 elastically support the inside end of the engaging piece 124 while the central portion of the connecting support plate 125 is supported by the support rib 126.

The support convex strip 131 bent in the bow shape supports the engaging piece 124 while absorbing the deformation of the lid unit 127. Therefore, the engaging pieces 124 support the semiconductor wafers 120 with the even forces.

In each of the engaging pieces 124, the inside end is elastically supported by the relatively strong force, and the outside end is elastically supported by the relatively weak force. At this point, the engaging piece 124 is in contact with the semiconductor wafer 120 while the bottom portion of the fitting groove 124A is arranged along the tangential direction of the circumference of the semiconductor wafer 120, and the force pressing the semiconductor wafer 120 is equalized as a whole by automatically adjusting the elastic forces of the two engaging pieces 124 so as to become equal to each other. Therefore, the semiconductor wafers 120 are stably supported.

As with the first embodiment, the rotating torque of the latch key is transmitted to the latch and converted into the push-out force of the latch member 42. Then, the latch member 42 engages the container main body 12 to convert the push-out force into the force pressing the lid unit 127 against the container main body 12 and the force pressing the wafer retainer 121 against the semiconductor wafers 120. The force pushed back from the semiconductor wafers 120 returns to the lid unit 127. Therefore, even if the container main body 12 is not fixed, the lid unit 127 can be attached and detached without shifting the container main body 12 by the force generated when the latch key is rotated.

When the vibration is applied to the thin-plate supporting container in conveying the thin-plate supporting container, the semiconductor wafers 120 are also vibrated. Further, the engaging pieces 124 are also vibrated according to the vibration of the semiconductor wafers 120.

For the gentle vibration, since amplitude of the engaging piece 124 is small, the contact point between the semiconductor wafer 120 and the engaging piece 124 is located outside (for example, near the contact point A in Fig. 42), and the elastic support plate 123 is mainly deformed to support the semiconductor wafer 120 with the weak elastic force.

For the violent vibration, although the amplitude of the engaging piece 12 4 becomes large, the contact point between the semiconductor wafer 120 and the engaging piece 124 is moved toward the inside (for example, near the contact point B in Fig. 42) as the amplitude of the engaging piece 124 is increased. The force which is applied to the connecting support plate 125 from the elastic support plate 123 is increased according to the amount of movement, and the elastic force is increased. When the semiconductor wafer 120 is largely vibrated, the engaging pieces 124 push back the semiconductor wafer 120 with the strong elastic force to suppress the vibration of the semiconductor wafer 120. Therefore, the force supporting the semiconductor wafer 120 is automatically changed according to a magnitude of the vibration to securely support the semiconductor wafer 120.

In the above-described vibration absorbing mode, the engaging pieces 124 support the semiconductor wafers 120 up to the amount of displacement of about 0.5 mm. Further, the engaging pieces 124 absorb the position shifts of the semiconductor wafers 120 to securely support the semiconductor wafers 120 up to the amount of displacement of 1.5 mm (2.5 mm at the maximum depending on design), and the engaging pieces 124 absorb the vibration and shock from the outside by the elastic displacement up to the amount of displacement of 1.5 mm (2.5 mm at the maximum depending on design). For the large shock and the like, in addition to the structural shock absorbing function, the shock is absorbed at the first stage in which the engaging piece 124 is elastically displaced up to the amount of displacement of about 1.5 mm (2.5 mm at the maximum depending on the design). When the elastic displacement exceeds 1.5 mm (2.5 mm at the maximum depending on the design), the shock is absorbed at the second stage in which the spring resistance force is rapidly increased by the characteristics previously set to the elastic support plate 93 or the contact with the backside of the lid units 14 and 15.

As a result, all the semiconductor wafers 120 are supported by the even forces, the vibrations of the semiconductor wafers 120 can be suppressed to the minimum against the outside vibration, and the semiconductor wafers 120 can be prevented from rotating.

Further, as with the first embodiment, the spring resistance force can be prevented from rapidly increasing to provide the thin-plate supporting container which is excellent for the vibration-resistant performance and shock-resistant performance, and the automatization of the attachment and detachment of the manufacturing line lid unit 15 can be easily realized.

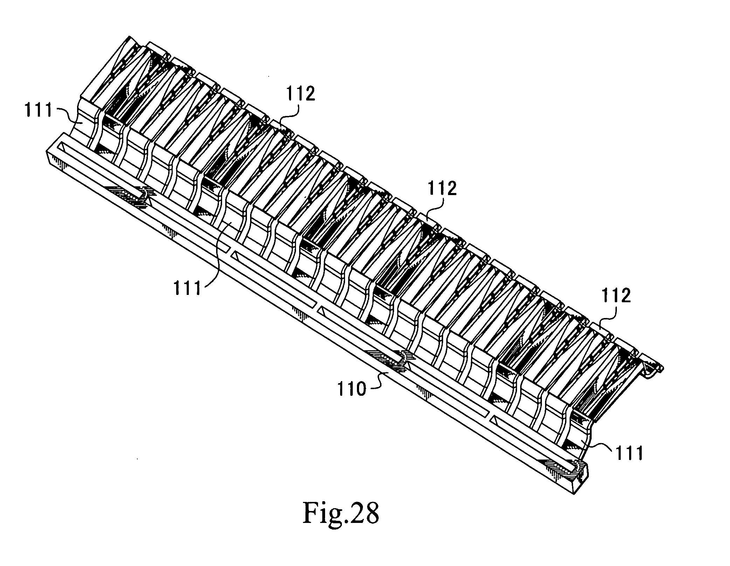

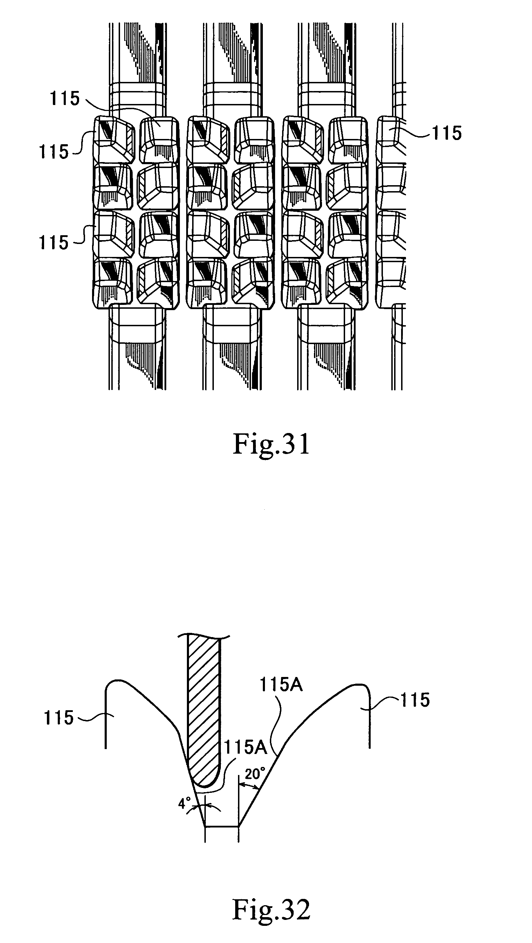

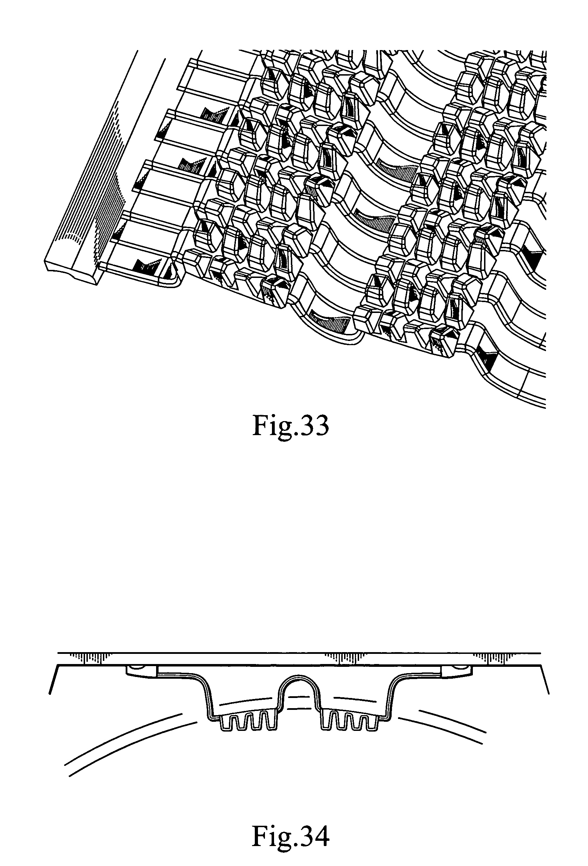

Modification examples
(1) In the first and second embodiments, the 300 mm-diameter semiconductor wafer is described as an example. However, even if the semiconductor wafer has the different diameter, the invention can be applied. In this case, the maximum amounts of the wafer retainer 91 and the like are set in the range of 1/200 to 1/120 of the diameter of the semiconductor wafer. The same operations and effects as in the first and second embodiments can be obtained even in this case.
(2) In the first embodiment, the wafer retainer 91 includes the base-end support portion 92, the elastic support plate 93, and the engaging piece 94. However, as shown in Figs. 26 to 28, it is possible that the wafer retainer includes a base-end support portion 110, an elastic support plate 111, and an engaging piece 112. The elastic support plate 111 supports one end of the base-end support portion 110 while the base-end portion of the elastic support plate 111 is fixed to the base-end support portion 110. The elastic support plate 111 extends from the other end of the engaging piece 112 to the lower surface of the manufacturing line lid unit 15. The engaging piece 112 includes a slope 112A and an engaging piece 112B, and the slope 112A and the engaging piece 112B substantially have the same functions as the slope 96A and the engaging piece 96B. Each three of support pawls 113 are alternately arranged while being opposite one another. The number of support pawls 113 is set as necessary.
   In this configuration, the same operations and effects as in the first and second embodiments can also be obtained.

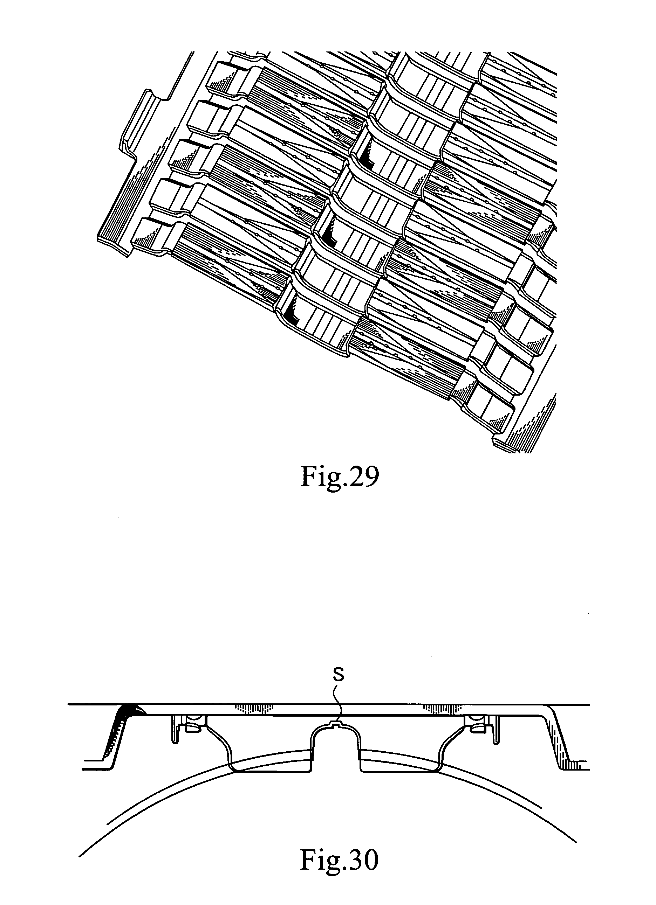

(3) In Figs. 20 and 21, the wafer retainer 91 has the cantilever structure. However, as shown in Figs. 29 and 30, it is possible that the wafer retainer has a structure in which the both ends of the wafer retainer are supported. In the wafer retainer shown in Figs. 29 and 30, the elastic support plate is attached between and on both side of the engaging pieces, and the elastic support plate located between the engaging pieces supports the engaging pieces while floating slightly from the lower surface of the manufacturing line lid unit 15 by a gap S.
   Since the elastic support plate located between the engaging pieces supports the engaging pieces while floating slightly from the setting surface, usually the thin plates are supported with the relatively weak force. When the large shock is applied from the outside like the case in which the thin-plate supporting container falls down by mistake, the gap S is eliminated and the elastic support plate located between the engaging pieces engages the support surface to strongly support the engaging pieces. Therefore, the thin plates are protected from the violent shock.
(4) In the first embodiment, the semiconductor wafers are supported by the support pawls 97. However, it is possible that the semiconductor wafers are supported by blocks. As shown in Figs. 31 and 32, two blocks 115 are alternately arranged while facing each other in the same way as for the first embodiment. That is, while each four sets of two blocks 115 facing each other are arranged at constant intervals, the blocks 115 are alternately arranged. Further, in a set of two blocks 115, engaging surfaces 115A are set to 4° and 20° with respect to the vertical line respectively, and the engaging surface 115A which the semiconductor wafer engages is set to 4°. Therefore, the circumference of the semiconductor wafer is sandwiched and held at the angle of 4° on one side (8° on both sides), so that the semiconductor wafer can be securely supported with no shift.
   In this case, it is also possible that the blocks are provided in the manner shown in Figs. 33 and 34. The blocks shown in Figs. 33 and 34 substantially have the same configuration as for the support pawls shown in Figs. 29 and 30, and the same operations and effects can be obtained.
(5) In the first embodiment, the lid unit for a thin plate supporting container is used in the manufacturing line. However, the lid unit for a thin plate supporting container can also be used in the storage and the transport. In this case, the same operations and effects as in the first embodiment can also be obtained.
(6) In the first embodiment, the two simplified detaching mechanisms 32 are provided in the manufacturing line lid unit 15. However, according to the specification and standard, it is also possible that one simplified detaching mechanism 32 or at least three simplified detaching mechanisms 32 are provided in the manufacturing line lid unit 15.
(7) In the first embodiment, the lid unit for a thin plate supporting container is applied to the storage container of the semiconductor wafers. However, the invention is not limited to the storage container of the semiconductor wafers, but the invention can be applied to the storage container of other thin plates. In this case, the same operations and effects as in the first embodiment can also be obtained.
(8) In the first embodiment and the modification example, the wafer retainer which is of the thin-plate retainer for supporting the thin plates stored in the container main body is applied to the thin-plate supporting container 11 of the first embodiment. However, the invention is not limited to the thin-plate supporting container 11 of the first embodiment, but the invention can be applied to the thin-plate supporting containers having other structures. In this case, the same operations and effects as in the first embodiment can also be obtained.
(9) In the first embodiment, the lid unit holder 100 is applied to the thin-plate supporting container 11. However, the invention is not limited to the thin-plate supporting container 11 of the first embodiment, but the invention can be applied to the thin-plate supporting containers having other structures. In this case, the same operations and effects as in the first embodiment can also be obtained.
(10) In the second embodiment, the two engaging pieces 124 are provided in the wafer retainer 121. However, it is also possible to provide at least three engaging pieces 124. In the case where at least three engaging pieces 124 are provided, the connecting support plate 125 and the support rib 126 are provided between the engaging pieces 124. In this case, the same operations and effects as in the second embodiment can also be obtained.
(11) In the second embodiment, the horizontal plate 125C is supported by the support convex strip 131. However, it is also possible that a support projection is provided in the central portion of the horizontal plate 125C. In the case where the support projection is provided, it is not necessary to provide the support convex strip 131. The support projection engages the support convex strip 131 to support the horizontal plate 125C when the support convex strip 131 is provided, and the support projection engages the backside of the lid unit 127 to support the horizontal plate 125C when the support convex strip 131 is not provided.
   When the support convex strip 131 is not provided, the height of the support projection is set at the central portion of the horizontal plate 125C so that the central portion is higher than the both end portions as in the second embodiment. When the support convex strip 131 is provided, the total heights of the support projection at the central portion of the horizontal plate 125C and the support convex strip 131 are set so that the central portion is higher than the both end portions. In this case, the same operations and effects as in the second embodiment can also be obtained.
(12) In the second embodiment, the fitting groove 124A of the engaging piece 124 is formed in a V-shape. However, like the engaging piece 94 of the first embodiment, it is also possible to include the alternately arranged support pieces. That is, like the engaging piece 94 of the first embodiment, it is possible that the engaging piece 124 of the second embodiment includes the two blocks 96 and the alternately arranged support pawls 97 (support pieces). Therefore, the alternately arranged support pieces alternately engage the circumference of the semiconductor wafer 120 to securely support the semiconductor wafer 120. As a result, while the vibration of the semiconductor wafer 120 can be suppressed to the minimum against the outside vibration, the semiconductor wafer 120 can be securely prevented from rotating.
(13) The configuration in which the wafer retainer 121 supports the engaging piece 124 is not limited to the second embodiment, but other configurations can be adopted as long as the engaging pieces 124 located in the central portion can be arranged while arising toward the semiconductor wafers 120 further than the engaging pieces 124 located on the both-side portions.
   For example, it is possible that the elastic support plate 123 is formed such that the engaging pieces 124 located in the central portion arises toward the semiconductor wafers 120 further than the engaging pieces 124 located on the both-side portions. It is also possible that one of or both the elastic support plate 123 and the connecting support plate 125 are formed such that the engaging pieces 124 located in the central portion arises toward the semiconductor wafers 120 further than the engaging pieces 124 located on the both-side portions.
(14) In the second embodiment, the connecting support plate 125 is supported by the support rib 126. However, it is also possible that the connecting support plate 125 is supported by a projection. Specifically, as shown in Fig. 45, it is possible that the connecting support plate 125 is supported by a fitting projection 142. The fitting projection is fitted in a fitting hole 141 made in the connecting support plate 125, which allows the fitting projection 142 to prevent the connecting support plate 125 from shifting along the backside of the lid unit to permit the movement of the connecting support plate 125 in the direction perpendicular to the backside of the lid unit. In this case, the same operations and effects as in the second embodiment can also be obtained.

## Claims

1. A lid unit for a thin plate supporting container with which a container main body of a thin-plate supporting container is covered, the thin-plate supporting container in which a plurality of disk-shaped thin plates are stored and conveyed,
the lid unit comprising a thin-plate retainer which supports the disk-shaped thin plates stored in the container main body,
wherein the maximum amount of displacement of the thin-plate retainer is set in a range of 1/200 to 1/120 of a diameter of the disk-shaped thin plate.

2. A lid unit for a thin plate supporting container with which a container main body of a thin-plate supporting container is covered, the thin-plate supporting container in which a plurality of disk-shaped thin plates having diameter of 300 mm are stored and conveyed,
the lid unit comprising a thin-plate retainer which supports the disk-shaped thin plates stored in the container main body,
wherein the maximum amount of displacement of the thin-plate retainer is set in a range of 1.5 mm to 2.5 mm.

3. The lid unit for a thin plate supporting container according to claim 1, wherein proportionality is held between the amount of displacement of the thin-plate retainer and external force when the maximum amount of displacement of the thin-plate retainer ranges from 1.5 mm to 2.5 mm.

4. The lid unit for a thin plate supporting container according to claim 1 or 2, wherein the thin-plate retainer is arranged at a position in which the thin-plate retainer is not in contact with the disk-shaped thin plates stored in the container main body or at a position in which the thin-plate retainer is in slight contact with the disk-shaped thin plates in a state that the thin-plate retainer is fitted in the container main body and any force is not applied.

5. The lid unit for a thin plate supporting container according to claim 1 or 2, further comprising a support convex strip which is molded such that both end sides are thinned and a central side is thickened, the support convex strip absorbing deformation of the lid unit to support the disk-shaped thin plates with even force.
